# EUROPEAN PATENT APPLICATION

(11) **EP 1 513 194 A2**
(43) Date of publication of application: **09.03.2005**
(21) Application number: 04255387.5
(22) Date of filing: 03.09.2004
(51) Int. Cl.: H01L 23/473

(54) **Cooling device for semiconductor component**

(30) Priority: 04.09.2003 JP 2003313123
(71) Applicant: FANUC LTD, Minamitsuru-gun, Yamanashi 401-0597 (JP)
(72) Inventor: Sakano, Tetsuro, Asao-ku Kawasaki-shi Kanagawa 215-0001 (JP); Takigawa, Hiroshi, Isehara-shi Kanagawa 259-1117 (JP); Nishikawa, Yuji Room 14-408, Fanuc Manshonharimoni, Minamitsuru-gun Yamanashi 401-0511 (JP); Hayano, Koji Room 14-505, Minamitsuru-gun Yamanashi 401-0511 (JP); Ohyama, Akinori Room 11-201, Minamitsuru-gun Yamanashi 401-0511 (JP)
(74) Representative: Billington, Lawrence Emlyn

(57) **Abstract**

A cooling device (1) for a semiconductor component which increases mechanical strength thereof and reduces a pressure loss of coolant. Plate members (2-4) constituting the cooling device are formed with flow passages such as coolant supply (8) and discharge openings (9), grooves (14) divided by ridges (13), and through portions separated by projections (15) or partitions (16). The ridges, projections, and partitions are joined to a adjacent plate member to increase the joining strength, which is further increased by forming the ridges, projections, and partitions of different plate members at the same positions. In the case of laminating the plate members having surfaces formed with solder layers, a number of minute vacant spaces (12) are formed in those joining faces of the plate members which are not formed with passages, etc., and solder filets are formed over the entire joining faces to increase the joining strength. The grooves and through portions can be formed by chemical etching together with outer shapes of the plate members. A plurality of plate members can be fabricated from a single sheet material at a time.

## Description

### BACKGROUND OF THE INVENTION

### 1. Field of the Invention

The present invention relates to a cooling device for cooling an electronic device component such as a semiconductor laser component, and more particularly, to a cooling device comprising laminated plate members in which coolant is caused to flow for the cooling, and having an improved structure with mechanical strength large enough to prevent the plate members from being peeled off or deformed.

### 2. Description of Related Art

Laser can be used as means for welding, cutting, and the like. In such laser applications requiring a high output, a semiconductor laser has recently been used as a light source for pumping solid-state laser such as Nd:YAG laser or for direct processing. This is because the semiconductor laser has the following features: electro-optical conversion efficiency of about 50% higher than any other laser; easy to construct an optical system since wavelength can be relatively easily selected in a range from visible to near-infrared, so that an optical fiber cable can be used for transmission; and compact in size and long in service life.

Since a semiconductor laser used for machining purposes is demanded to have a high output in the order of kW, there is often used a linear array comprised of monolithically integrated LDs (laser diodes). The required output is obtained by using a large number of arrayed semiconductor laser devices each having a linear LD array mounted thereon.

A semiconductor laser generates joule heat equivalent to a light output energy thereof. An integrated linear LD array that generates heat energy of several tens W requires a cooling device for preventing the decrease in optical output and deterioration in characteristic due to the rise in temperature of semiconductor laser. For such a high-output linear LD array, an active cooling device is often used that causes coolant such as cooling water to flow.

The cooling device is required to have a high cooling performance and reliability enough to ensure a long service life of semiconductor laser. In addition, the cooling device must be small in volume and low in cost since it is used in large numbers, as in the case of linear LD array. The characteristic of having a high cooling performance is considered to include a feature that a pressure loss in a coolant flow passage of the cooling device is low enough to achieve the required cooling performance at a low coolant supply pressure.

As a cooling device using coolant for cooling linear LD arrays, there is the one comprised of laminated plate members. To join the laminated plate members together, there is a joining method in which plate members formed at their surfaces with solder layers are subject to temperature rise while being applied with a pressure in a state they are stacked in layer.

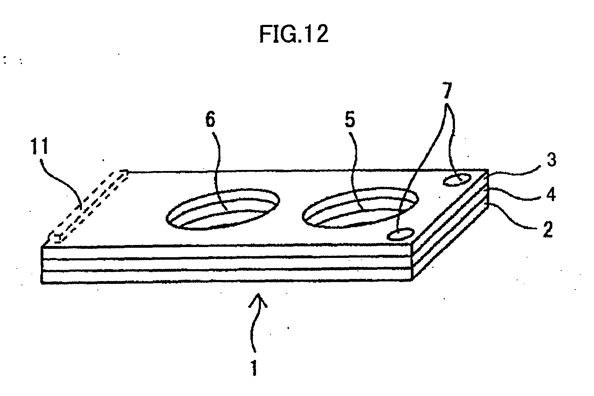

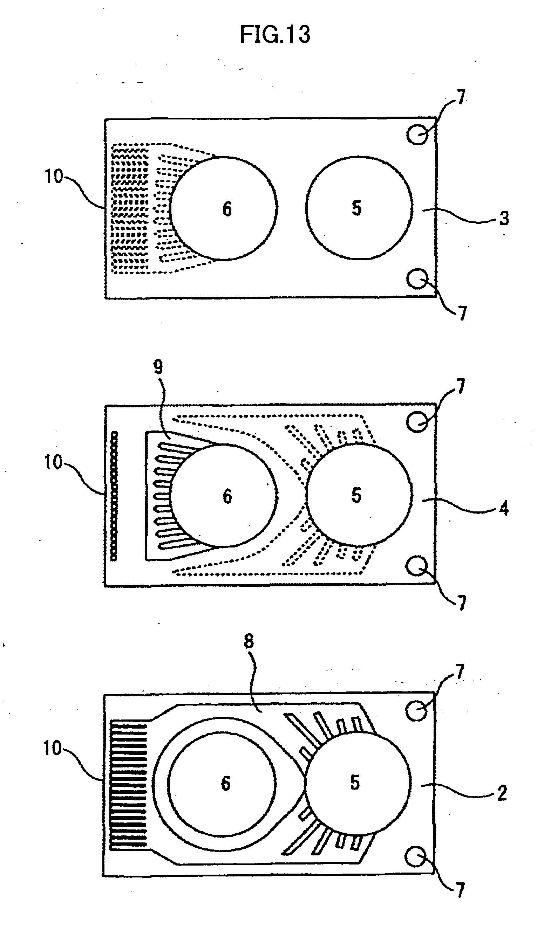

From the viewpoint of cost, solder joining is superior to diffusion welding which requires higher pressure and higher processing temperature. In addition, since a solder layer is formed on an inner wall face that defines a coolant flow passage, there is advantage that wall erosion due to coolant can be prevented without making costly thick Au plating or the like. FIG. 12 shows in a perspective view a cooling device 1 comprised of such a plate member laminate, and FIG. 13 shows in plan views conventional plate members used in the cooling device. In these plan views of the plate members, a dotted line represents a pattern that is formed in the rear of each plate member. Referring to these drawings, the cooling device is comprised of first and second plate members 2, 3 and a third plate member 4 disposed between these two plate members. A semiconductor laser (linear LD array 11) is mounted near a first side 10 of the cooling device 1 that is laminated to (stacked with) other cooling devices, with sealing members such as an O-ring interposed therebetween. By stacking the cooling devices together, inlet openings 5 and outlet openings 6 formed in the first, second and third plate members 2-4 become in communication with one another to form common passages through which coolant is supplied and discharged. Coolant flowing from the inlet openings 5 into a coolant supply passage 8 formed in the inner face of the first plate member flows through a through passage formed in the third plate member 4 near the first side 10, and absorbs heat energy generated by the semiconductor laser 11. Then, the coolant flows through a coolant discharge passage 9 of the third plate member, and is discharged to the outlet openings 6. Each of the plate members 2-4 is not provided with a pattern extending therethrough, other than the inlet opening 5, the outlet opening 6, and the through passage formed near the first side 10 of the third plate member 4. Each of the coolant supply and discharge passages 8 and 9 is formed in the form of a groove shallower than the thickness of the corresponding plate member.

It is understood that the above conventional plate members have their joining faces at which they are joined to one another and in which joining areas are widely distributed. The joining areas are ones at which the joining faces are in close contact with one another and which are provided with none of the inlet opening, the outlet opening, a coolant passage and a through portion 7 used for positioning the cooling device. Since the plate members are subject to temperature rise while being applied with a pressure, there remain substantially no solder on the joining areas.

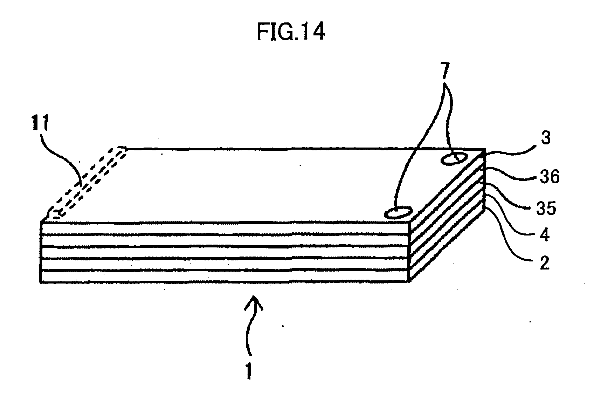

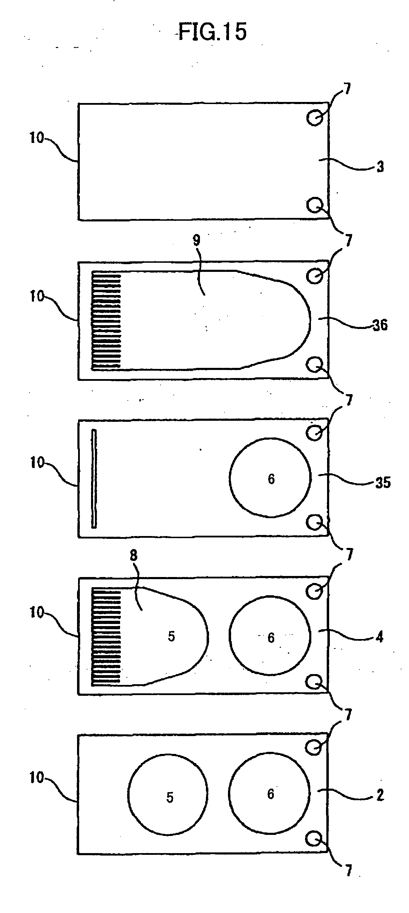

FIG. 14 shows in a perspective view another conventional cooling device 1, and FIG. 15 shows in plan views plate members used for the cooling device 1. Referring to these drawings, the cooling device 1 is comprised of first and second plate members 2, 3, and third, fourth and fifth plate members 4, 35 and 36 that are disposed between the first and second plate members. A semiconductor laser (linear LD array) 11 is mounted near the first side 10 of the cooling device 1. This conventional cooling device 1 is configured to be juxtaposed to other cooling devices in the direction in which the linear LD array extends, unlike the cooling device shown in FIGS. 12, 13 that are adapted to be stacked with other cooling devices in the direction perpendicular to the linear LD array 11. The second plate member 3 to which the linear LD array 11 is mounted is provided with none of the inlet opening 5 and the outlet opening 6. Coolant flowing from the inlet opening 5 in the first plate member 2 into the coolant supply passage 8 in the third plate member 4 flows through a through passage that is formed near the first side 10 in the fourth plate member 35, whereby heat energy generated by the semiconductor laser 11 is absorbed. Then, the coolant passes through the coolant discharge passage 9 formed in the fifth plate member 36, to be discharged to the outside of the cooling device through the outlet opening 6 in the first plate member 2.

In the cooling device 1 shown in FIGS. 14 and 15, a pattern formed in each of the plate members is constituted by a through portion extending through the plate member, the coolant supply passage 8 is formed only in the third plate member 4, and the coolant discharge passage 9 is formed only in the fifth plate member 36. Therefore, despite that the cooling device constituted by the plate members stacked in five layers is relative thick, the passages are narrow, resulting in a large pressure loss of coolant in the passages. When the pressure loss is large, the coolant supply pressure must be increased in order to cause the coolant to flow at the required flow rate so as to achieve the required cooling performance. As a result, not only load to a coolant circulating apparatus increases, but also the risk of a coolant leakage from the cooling device or from coolant supply and discharge pipes increases, lowering the overall reliability of a laser oscillation apparatus. By thinning each plate member to increase the number of plate member layers, it is possible to realize to some extent a cooling device which is thin and low in pressure loss. In such a device, however, that area of the second plate member 3 which corresponds to the opening formed in the adjacent plate member is not supported by the adjacent plate member or the like, and hence the second plate member can be bulged when receiving the coolant pressure, and can be dented when a pressure to prevent the coolant leakage is applied to the cooling device. Thus, there is a high possibility that one or more plate members are deformed.

There is a problem of a low joining strength between plate members in that cooling device, among the foregoing prior arts, which is comprised of plate members stacked together and which has a solder layer formed in at least one of the joining faces of each pair of plate members to be joined. In particular, the joining strength is low because the plate members have joining faces mostly occupied by joining areas formed with none of the inlet opening, the outlet opening, the coolant passage, and the through portion used for positioning the cooling device, and hence there remains substantially no solder on the joining faces after the plate members are joined together by subjecting them to temperature rise while being applied with a pressure. The low joining strength allows the joined plate members to be peeled off when they receive a coolant pressure or a stress applied to the cooling device, sometimes causing a coolant leakage or the like to decrease the reliability of the cooling device.

It is possible to reduce the risk of the plate member being curled up at the joining areas by thickening the plate member. However, it is difficult to form the thick plate member by means of chemical etching which is low in processing cost. In the case of forming the thick plate member by means of chemical etching, it takes a long etching time or the like, resulting in increased processing cost. In addition, the volume of the cooling device increases, posing a problem that plate members are difficult to be densely arranged.

In the case of the cooling device comprised of the plate member laminate having an outer face thereof to which the linear LD array is mounted and which is not formed with inlet and outlet openings used for coolant supply and discharge, and having another opposite outer face thereof adapted for coolant supply and discharge, the reliability of the cooling device can sometimes be lowered such as for example that a coolant leakage occurs due to deformation of the plate member provided with no openings, which can be bulged when receiving a coolant pressure or can be dented when a pressure is applied to the cooling device in order to prevent a coolant leakage because areas of the just-mentioned plate member, corresponding to openings formed in an adjacent plate member and occupying a relatively wide area in the cooling device, are neither joined to nor supported by the adjacent plate member or the like.

As to this problem, the plate member can be prevented from being deformed by thickening the plate member. As described above, however, this makes it difficult to perform the forming by chemical etching which can reduce machining cost. Even if the forming by chemical etching can be realized, the etching requires a longer time, resulting in increased machining cost. Since the volume of the cooling device increases, another problem is posed that a dense arrangement is difficult to achieve.

In case that the coolant passage is formed to be narrower or shallower to decrease the cross section thereof, the mechanical strength of the plate member increases so that the risk of a coolant leakage due to plate member deformation may be lowered, but a pressure loss of coolant in the coolant passage increases. The increased pressure loss requires that the supplied coolant pressure be increased in order to cause the coolant to flow at the required rate to attain the predetermined cooling performance. As a result, not only load to the cooling circulation apparatus increases but also the risk of coolant leakage from the cooling device or the pipes for coolant supply and discharge increases, thus lowering the overall reliability of laser oscillation apparatus, as mentioned above. In case that the number of plate members used for one cooling device increases to increase the cross section of the coolant passage, the volume of the cooling device increases, and the cost thereof naturally increases.

### SUMMARY OF THE INVENTION

The present invention contemplates to provide a technical art of realizing a highly reliable, low-priced, and high performance cooling device, in which plate members are improved in construction to increase the joining strength of the plate members that are joined together by means of solder joining which is advantageous in cost, the plate members are thin ones which can be fabricated at low cost, a number of the plate members used is decreased to a minimum, the pressure loss is reduced, the mechanical strength is increased, and a risk of coolant leakage due to the plate member being peeled off, deformed, or the like is reduced. Further, there is provided a technical art of realizing a high output, highly reliable, and low-priced semiconductor laser device that is comprised of the aforesaid cooling device and a linear LD array mounted thereon.

The present invention provides a cooling device comprising: a laminate of at least three plate members stacked together, in which a passage for flowing coolant is formed in at least one of the plate members and a solder layer is formed on at least a joining face of at least one of the plate members which are joined and stacked together. In this cooling device, one or more vacant spaces are formed on at least one of the joining face on which the solder layer is formed and a joining face of another plate member opposed to the joining face on which the solder layer is formed. The one or more vacant spaces is formed as recesses, grooves or through holes other than an inlet opening for introducing the coolant, an outlet opening for discharging the coolant, a passage for flowing coolant, and a through hole formed for positioning of the cooling device. Molten solder gathers into the vacant spaces, so that solder filets are formed between the joining faces. As a result, joining areas at which the joining faces are in close contact with each other and on which there remains substantially no solder are limited to narrow areas, thus increasing the joining strength between the plate members, to thereby solve problems encountered in preventing a coolant leakage caused by the peeling-off of plate member.

It is preferable that joining areas of every opposed joining faces, at which these faces are in close contact with each other only through the solder layer, be narrow, such that a circle inscribed in each joining area has a diameter equal to or less than 3 mm, preferably about 1 mm, whereby an advantage of preventing the peeling-off of the plate member is achieved. Preferably, the vacant space be small, and has a narrow side of a length or a short diameter equal to or less than 1 mm, preferably about 0.3 mm, which is advantageous in preventing the peeling-off of the plate member. A spacing between adjacent vacant spaces is preferably to be equal to or less than 1 mm, more preferably about 0.2 mm, in order to prevent the peeling-off of the plate member.

The vacant space may be formed at a location invisible from outside after the plate members are stacked together, whereby the outer shape of the cooling device comprised of the plate member laminate can be kept unchanged even if solder gathers into the vacant space, thereby making it possible to avoid a problem caused by the provision of the vacant space. In the laminate, every opposed joining faces, if they are not formed with no vacant spaces, have large joining areas at which the joining faces are in close contact with each other. These joining areas can be made narrow by providing the vacant space in plural numbers at a narrow spacing at locations invisible from outside. Alternatively, the vacant space may be formed at a location visible from outside in such a manner that part of periphery of the vacant space is in coincidence with part of the outer periphery of the plate members. This makes it possible to provide the vacant space even at a relatively narrow joining area near the outer periphery of the plate members, thereby preventing the plate members from being peeled off at the outer periphery. The vacant space may be formed by means of chemical etching technique including half etching technique, which can suppress the machining cost.

The present invention also provides a cooling device for a semiconductor component comprising a laminate comprised of at least three plate members stacked together, in which a first plate member disposed on one outermost side of the laminate is formed with an inlet opening extending through the first plate member for introducing the coolant and an outlet opening extending therethrough for discharging the coolant, a second plate member disposed on another outermost side of the laminate is formed with none of an inlet opening and an outlet opening extending therethrough, and a third or fourth plate member and a further plate member that are disposed between the first and second plate members are formed with an opening extending therethrough, the opening being either one of inlet and outlet openings individually corresponding in position to the inlet and outlet openings formed in the first plate member. In the cooling device, a groove divided by one or more first ridges and shallower than a thickness of the second plate member is formed in at least part of at least either one of those areas of a face of the second plate member on a side opposite to the outer face of the laminate which respectively correspond to the inlet and outlet openings.

The mechanical strength is liable to decrease at areas, corresponding to the inlet and outlet openings, of the second plate member disposed on another outermost side of the laminate, the areas being formed with none of an inlet opening and an outlet opening extending therethrough, because these areas are ordinarily not joined to the adjacent plate member. Thus, the second plate member is liable to be deformed when receiving a coolant pressure and a stress exerted from the outside. It is possible to prevent the deformation of the second plate member while increasing the cross section of coolant flow passage, by forming the groove, divided by first ridges and shallower than a thickness of the second plate member, in the area of the face of the second plate member on the side opposite to the outer face of the laminate, the area corresponding to the inlet or outlet opening.

A passage comprised of a plurality of grooves that are divided by second ridges and shallower than a thickness of the plate members may be formed in an area of the second plate member other than the areas respectively corresponding to the inlet and outlet openings, and the first ridges formed in the second plate member may be connected to the second ridges formed in the second plate member, which makes it possible to suppress the decrease in mechanical strength of the plate member due to the provision of the passage to a minimum. A pressure loss of coolant due to confluent and diffluent of passage can also be suppressed to a minimum.

The present invention also provides a cooling device for a semiconductor component comprising a laminate comprised of at least three plate members stacked together, in which a first plate member disposed on one outermost side of the laminate is formed with an inlet opening extending through the first plate member for introducing the coolant and an outlet opening extending therethrough for discharging the coolant, a second plate member disposed on another outermost side of the laminate is formed with none of an inlet opening and an outlet opening extending therethrough, and a third or fourth plate member and a further plate member that are disposed between the first and second plate members are formed with an opening extending therethrough, the opening being either one of inlet and outlet openings individually corresponding in position to the inlet and outlet openings formed in the first plate member, and in which the inlet and outlet openings of the first plate member are separated by first partitions, respectively.

In the cooling device comprising the laminate that includes the second plate member disposed on one outermost side of the laminate and formed with none of inlet and outlet openings extending therethrough, the inlet and outlet openings formed in the first plate member are used only for coolant supply and discharge to and from the cooling device, respectively, and therefore, the increase in a pressure loss of coolant at the inlet and outlet openings is negligible, even if these openings are made slightly narrow in area. In this regard, the provision of the first partitions in the inlet or outlet opening of the first plate member makes it possible to increase the mechanical strength of the cooling device while causing little increase in pressure loss of coolant.

The first partitions formed in the first plate member may be connected to second ridges formed in the passage of the first plate member. This makes it possible to suppress the decrease in mechanical strength of the plate member due to the provision of the passage to a minimum, and also suppress a pressure loss of coolant due to confluent and diffluent of passage to a minimum.

In the cooling device comprising the laminate that includes the second plate member disposed on one outermost side of the laminate and formed with none of inlet and outlet openings extending therethrough, the inlet and outlet openings formed in the third or fourth and further plate members are used only for coolant supply and discharge to and from the cooling device, respectively, and therefore, the increase in a pressure loss of coolant at the inlet and outlet openings is negligible, even if these openings are made slightly narrow in area. Thus, at least part of those areas of the third or fourth and further plate members which respectively correspond to the inlet and outlet openings may be formed with third ridges that divide a groove shallower than the thickness of the plate members, or first projections which are not open and to which the plate members project, or second partitions. Further, at least part of the first ridges formed in that area of the second plate member which corresponds to the opening may be formed at positions corresponding to the third ridges or the first projections or the second partitions formed in the third or fourth and further plate members adjacent to the second plate member, and may be joined thereto. This makes it possible to further increase the mechanical strength of that area of the second plate member which corresponds to the opening, and prevent the bulging of the plate member at that area caused by the coolant pressure.

Furthermore, the first partitions formed in that area of the first plate member which corresponds to the opening may be formed at positions corresponding to the first projections or the second partitions or the third ridges that are formed in the third or fourth and further plate members adjacent to the first plate member, and may be joined to the first projections or the second partitions or the third ridges, so as to further increase the mechanical strength at the area corresponding to the opening.

The first projections or the second partitions or the third ridges that are formed in the third or fourth and further plate members may be connected to the second ridges formed in the same plate members. This makes it possible to suppress the decrease in mechanical strength of the plate member due to the provision of the passage to a minimum, and also suppress a pressure loss of coolant due to confluent and diffluent of passage to a minimum.

In the cooling device where a plurality of plate members, including the third or fourth and further plate members, are disposed between the first and second plate members, the first projections or the second partitions or the third ridges formed in one of the third or fourth and further plate members may be formed to correspond in position to the first projection or the second partitions or the third ridges formed in another plate member adjacent to the one of the third or fourth and further plate members, and may be joined to the first projection or the second partitions or the third ridges formed in the another plate member, whereby the mechanical strength at the area corresponding to the opening can be further increased.

A flow passage comprised of a through portion having second projections or a through portion separated by third partitions may be formed in an area that is other than those areas of the third or fourth and further plate members which individually correspond to the inlet and outlet openings, in addition to the through holes provided close to the first side of the plate members. As a result, the cross section of the coolant flow passage increases, making it possible to reduce a pressure loss of coolant while preventing the decrease in the mechanical strength of the cooling device. By joining the second ridges or the second projections or the third partitions to the plate member disposed adjacent thereto, the mechanical strength of the cooling device can be increased further.

The through holes provided close to the first side of the third or fourth and further plate members may be a through hole array in which a plurality of through holes arranged in line and separated by fourth partitions. This makes it possible to prevent a deformation of the plate members near the first side thereof, and increase the mechanical strength of the cooling device. By joining the fourth partitions formed in the third or fourth and further plate members to the second ridges of the plate member disposed adjacent thereto or to the fourth partitions formed in the third or fourth and further plate members, the mechanical strength of the cooling device in the vicinity of the first side thereof can be further increased. By connecting the fourth partitions formed in the third or fourth and further plate members to the second ridges formed in the same plate members, the decrease in mechanical strength of the plate members due to the provision of the passage can be suppressed to a minimum, and the pressure loss of coolant due to confluent and diffluent of passage can also be suppressed to a minimum.

In a cooling device comprising the laminate that includes the second plate member disposed on one outermost side of the laminate and formed with none of inlet and outlet openings extending therethrough, the cooling device may comprise a flow passage structure in which the outlet opening is provided closer in position to the first side of the plate members than the inlet opening, and in which the coolant flowing into from the inlet opening passes through the coolant supply passage formed in at least either one of the first plate member and that one of the third or fourth and further plate members which is disposed adjacent to the first plate member so as to bypass the outlet opening, passes through the coolant discharge passage formed in at least either one of the second plate member and that one of the third or fourth and further plate members which is disposed adjacent to the second plate member by way of the through holes formed in the third or fourth and further plate members so as to be close to the first side of the plate members, and is then discharged to the outlet opening. In the cooling device, part of the coolant supply passage comprised of grooves shallower than the thickness of the plate members may be formed in the face of the second plate member which is opposite to its another face serving as the outer face of the laminate, whereby a pressure loss of coolant can be reduced.

In the present invention, the terms of inlet opening, outlet opening, coolant supply passage, and coolant discharge passages are used on the assumption that the coolant is caused to flow in the direction toward the second plate member on which the semiconductor component to be cooled is mounted, or in other words, the coolant is caused to flow so as to pass through the through holes provided close to the first side of the third or fourth and further plate members from the first plate member side to the second plate member side. Of course, the coolant may be caused to flow in the reverse direction such that it flows into the outlet opening, and then passes through the coolant discharge passage and the coolant supply passage, to be discharged to the inlet opening.

In a cooling device comprising the laminate that includes the second plate member disposed on one outermost side of the laminate and formed with none of inlet and outlet openings extending therethrough, the cooling device may comprise a flow passage structure in which the inlet opening is provided closer in position to the first side of the plate members than the outlet opening, and in which the coolant flowing into from the inlet opening passes through the coolant supply passage formed in at least either one of the first plate member and that one of the third or fourth and further plate members which is disposed adjacent to the first plate member, passes through the coolant discharge passage formed in at least either one of the second plate member and that one of the third or fourth and further plate members which is disposed adjacent to the second plate member by way of the through holes formed in the third or fourth and further plate members so as to be close to the first side of the plate members, and is then discharged to the outlet opening. In the cooling device, the entire width of the coolant passage including the second ridges and the groove divided by these second ridges, or the entire width of the coolant passage including the second projections and the through portion having the second projections, or the entire width of the coolant passage including the third partitions and the through portion separated by the third partitions may be equal to or broader at any position than the diameter or equivalent width of the inlet or outlet opening, whereby the cooling device in which a pressure loss of coolant is reduced and which is high in mechanical strength can be realized.

By forming the second ridges or the third partitions constituting the coolant supply passage at positions corresponding to the second ridges or the third partitions constituting the coolant discharge passage, the mechanical strength of the cooling device resisting to an external pressure applied thereto can be increased.

In the cooling device in which the laminate includes three or more plate members, including the third, fourth and fifth plate members and a further plate member, that are disposed between the first and second plate members, the plate members disposed closer to the first plate member than to the center of the laminate may have substantially the same flow passage structure, and/or the plate members disposed closer to the second plate member than to the center of the laminate may have substantially the same flow passage structure, so as to increase the mechanical strength of the cooling device resisting to an external pressure applied thereto. In case that four or more plate members are disposed between the first and second plate members, a plurality of plate members which have the completely same structure may be used to thereby prevent the increase in cost due to the increase in number of parts.

In the cooling device in which the laminate includes three or more plate members, including the third, fourth and fifth plate members and a further plate member, that are disposed between the first and second plate members, at least one of the third or fourth and further plate members disposed closer to the first plate member than to a center of the laminate may be provided with a coolant buffer, which is a through area extending over the entire width of the coolant supply passage, at a location closer to a center of these plate members than to the through holes provided close to the first side of the plate members. In this case, coolants having passed through different flow passages provided with corresponding ones of the first through third ridges, the first and second projections, and the first through third partitions meet at the coolant buffer in which the coolant pressures are made equal, and the resultant coolant flow uniformly enters the through holes provided close to the first side of the plate members, whereby a semiconductor component, especially, a long semiconductor component such as a linear LD array, can uniformly be cooled.

The grooves divided by the first, second, or third ridges and shallower than the thickness of the plate members, the opening divided by the first or second partitions, the through portion separated by the third partitions and forming the flow passage, the through holes provided close to the first side of the plate members, the opening having the first projections, and the through portion having the second projections and forming the flow passage may be formed by means of chemical etching technique including half etching technique, to suppress the increase in machining cost.

In a cooling device in which the laminate includes three or more plate members, including the second plate member disposed on one outermost side of the laminate and formed with none of inlet and outlet openings extending therethrough, the plate members may be joined and stacked together by means of diffusion welding, to realize the cooling device having a high mechanical strength. Alternatively, a solder layer may be formed on joining faces of the plate members for joining and stacking them together. This method is advantageous in cost because the joining can be made at lower pressure and lower processing temperature as compared to diffusion welding. In addition, since a solder layer is formed on an inner wall face that defines a coolant flow passage, there is an advantage that wall erosion due to coolant can be prevented without making costly thick Au plating or the like.

When the plate members are joined by means of soldering, at least part of the first through third ridges or the first through fourth partitions or the first or second projections in one of the plate members may be so formed as to nearly correspond in position to at least part of the first through third ridges or the first through fourth partitions or the first or second projections in the adjacent plate member, and a set of ones to be joined to each other may have different widths measured at their corresponding positions or may be deviated in position from each other in a widthwise direction in a range smaller than their widths measured at their corresponding positions, and a solder filet may be formed at their joined portions. This makes it possible to increase the joining strength to thereby prevent deformation of the plate members such as peeling-off thereof.

The plate members of the cooling device may be made of cupper or a cupper alloy, which is high in coefficient of thermal conduction, to realize the cooling device having high cooling performance. The plate members made of cupper or a cupper alloy can be diffusion welded, and can also be solder-joined when a solder layer is formed in joining faces. Solder of the solder layer used to join the plate members may be a material selected from a group consisting of Sn, a eutectic binary or more complex Sn-based alloy, In, a binary or more complex In-based alloy, Ni, and a binary or more complex Ni-based alloy. The solder layer may be formed by means of vapor deposition or plating. A metal film may be formed to provide a primary coating for the solder layer. A material for the metal film may be Ni, Ti, Pt, Cr, or the like.

In the cooling device, the inlet opening, the outlet opening, the coolant flow passage, the through portion used to position the cooling device, the vacant space, which are to be formed in the plate members, and the outer shapes of the plate members may all be formed only by means of chemical etching technique including half etching technique, whereby the cooling device which is low in pressure loss of coolant and high in mechanical strength can be realized without increasing the machining cost. In particular, when all the formings of the plate members are performed only by means of half etching deeper than half the thickness of the plate member from one face of each plate member and half etching deeper than half the thickness of the plate members from another opposite face of each plate member, the machining cost can be reduced.

In addition to the aforementioned parts, all of the following can also be formed only by means of chemical etching technique including half etching technique: the groove provided in the second plate member and divided by the first ridges; the opening provided in the first plate member and separated by the first partitions; the opening formed in the third or fourth and further plate members and having the first projections or separated by the second partitions; the groove provided in the third or fourth and further plate members and divided by the third ridges; the through portion having the groove separated by the second ridges or having the second projections or separated by the third partitions; and the through hole array provided close to the first side and separated by the fourth partitions. Only by means of half etching deeper than half the thickness of the plate member from one face of each plate member and half etching deeper than half the thickness of the plate member from another opposite plate member, all the formings of the plate members including the just-mentioned various parts can be performed. This makes it possible to keep low machining cost, even if the structure of the plate members is made complicated as mentioned above, in order to increase the mechanical strength of the cooling device and at the same time reduce the pressure loss of coolant.

By forming all the formings of the plate members only by means of half etching deeper than half the thickness of the plate member from one face of each plate member and half etching deeper than half the thickness of the plate member from another opposite plate member, a large number of plate members can be fabricated from one sheet material at a time. Further, a large number of cooling devices can be fabricated at low costs by machining a raw sheet material into a semi-finished product having a large number of plate members connected to one another through narrow bridges, and by cutting the semi-finished product so as to separate the plate members from the bridges by using a press die or the like after the corresponding plate members are stacked and joined together.

A semiconductor laser which serves as a semiconductor component may be mounted to the cooling device which is, as mentioned above, high in mechanical strength and low in cost. The resultant semiconductor laser device can achieve a low temperature rise in the semiconductor laser, high output, high reliability, and low cost. When the semiconductor laser is a surface-emitting semiconductor laser, laser light can be emitted from vicinity of the first side of the cooling device, without being interrupted by the cooling device. In case that the surface-emitting semiconductor laser is a monolithic linear LD array provided with a plurality of laser emitters, the linear LD array may have a width which is substantially equal to the width of the through holes provided close to the first side of the plate members or to the entire width of the through hole array including the fourth partitions, whereby the linear LD array can be uniformly cooled and the laser emitters can exhibit uniform characteristics.

The semiconductor laser may be mounted to the cooling device through a substrate for semiconductor laser mounting that is formed with solder layers at least at a semiconductor laser mounting face and a joining face at which the substrate is joined to the cooling device. In this case, residual stress due to difference between coefficients of thermal expansion of the semiconductor laser and the cooling device can be reduced, whereby the reliability of the semiconductor laser device can be improved. Further, a recess or a groove may be formed in at least either one of that joining face of the substrate for semiconductor laser mounting at which the substrate is joined to the cooling device and that mounting face of the cooling device on which the substrate for semiconductor laser mounting is mounted, and a solder filet may be formed between the joining face of the substrate for semiconductor laser mounting and the mounting face of the cooling device, whereby the joining strength between the substrate for semiconductor laser mounting and the cooling device can be increased.

Using an insulating film whose opposite faces have an ability of adhesion, a thin metal sheet having a thickness about 50 µm or equal to or less than 100 µm may be bonded to an outface of the cooling device to which the semiconductor laser is mounted, and the thin metal sheet may be soldered to an electrode of the semiconductor laser having another electrode thereof provided in that face of the semiconductor laser which used to mount the semiconductor laser to the cooling device or to the substrate for semiconductor laser mounting, thereby performing wiring used for electric current supply to the semiconductor laser. This allows easy fabrication of the semiconductor laser device. In particular, the insulating film whose opposite faces have an ability of adhesion may be a double-sided adhesive thermosetting insulating film which is softened and exhibits adhesiveness when heated, which is hardened when returned to room temperature, and through which physical objects individually disposed on both sides of the film are bonded together. Since the double-sided adhesive thermosetting insulating film does not exhibit adhesiveness unless it is subject to temperature rise, it is easy to align the insulating film and the thin metal sheet. By using the double-sided adhesive thermosetting insulating film having a structure that thermosetting adhesive layers are formed in opposite faces thereof and an insulating layer comprised of a resin layer or the like hardly softened when heated is disposed in a center thereof, problems of an overflowing of adhesive when heated and the like can be prevented, whereby the risk of an electrical short-circuit between the cooling device and the thin metal sheet can be reduced. By forming a resin layer of polyimide or the like in part of the thin metal sheet, the risk of an electrical short-circuit between the cooling device and the thin metal sheet can also be reduced.

By forming a slit in or near at least those portions of the thin metal sheet which are soldered to the electrode of the semiconductor laser, residual stress due to difference between coefficients of thermal expansion of the thin metal sheet and the semiconductor laser can be reduced, whereby the reliability of the semiconductor laser device can be improved. This is in particular effective for a case where the semiconductor laser is a linear LD array, so that there is a large area to which the thin metal sheet is soldered.

By forming the insulating film and the thin metal sheet with notches into which positioning guide pins are fitted, the insulating film and the thin metal sheet can be mounted to the cooling device with accuracy, and the semiconductor laser device can be fabricated with a high yield.

As described above, according to the present invention, the peeling-off, denting, deformation, etc. of plate members that constitute the cooling device comprised of a plate member laminate can be prevented, whereby the mechanical strength and reliability thereof are improved. In addition, the cross sections of passages can be increased, making it possible to reduce a pressure loss of coolant and attain high cooling performance. The decrease in pressure loss can lower the required coolant supply pressure, and hence a coolant leakage can hardly occur, resulting in higher reliability. The plate members of the present invention have a construction that makes it possible to perform all the formings of a large number of plate members at a time by means of ordinary chemical etching which is low in processing cost. Thus, a highly reliable and high performance cooling device can be realized at low cost. A semiconductor laser device of the present invention comprises the cooling device of the present invention and a semiconductor laser which is mounted thereto. The semiconductor laser device, having a construction easy to fabricate and adapted to be assembled by a highly reliable mounting method, is the one which is high in reliability and performance and low in fabrication cost.

There is formed the vacant space that is comprised of a recess or a groove or a through portion, other than an inlet opening, an outlet opening, a coolant flow passage, and a through portion used to position the cooling device that are formed in the plate member, so that molten solder gathers into the vacant space and a solder filet is formed between joining faces of the plate members. As a result, joining areas at which the joining faces are in close contact with each other and on which there remains substantially no solder can be limited to narrow areas, resulting in advantages that the joining strength between the plate members is increased and a coolant leakage caused by the peeling-off of plate members is prevented, without increase in processing cost.

In particular, by forming the vacant space at a location invisible from outside after the plate members are stacked together, the outer shape of the cooling device constituted by the plate member laminate can be kept unchanged even if solder gathers into the vacant space. In this manner, a problem caused by the provision of the vacant space can be avoided. In the laminate in which, if no vacant space is formed, large joining areas at which joining faces are in close contact with one another are present, it is possible to make the joining areas narrow by forming small vacant spaces at a narrow spacing at locations invisible from outside.

In particular, by forming the vacant space at a location visible from outside in such a manner that part of periphery of the vacant space is in coincidence with part of outer periphery of the plate members, the vacant space can be provided even at a relatively narrow joining area near the outer periphery of the plate members, thereby preventing the plate members from being peeled off at the outer periphery.

The machining cost can be suppressed, especially when the vacant space is formed by means of chemical etching technique including half etching technique.

In a cooling device in which a first plate member 2 disposed on one outermost side of a laminate is formed with an inlet opening for introducing coolant and an outlet opening for discharging the coolant and a second plate member 3 disposed on another outermost side of the laminate is formed with none of an inlet opening and an outlet opening, the provision of those partitions, projections, ridges, etc. which are formed in areas of each plate member corresponding to the inlet and outlet openings so as to be joined to the partitions, projections, and ridges of the adjacent plate member makes it possible, without causing the increase in coolant pressure loss, to increase the mechanical strength at and around the just-mentioned areas having large openings corresponding to the inlet and outlet openings and liable to be decreased in mechanical strength. As a result, it is possible to prevent the areas corresponding to the openings from being deformed, more specifically, from being dented when receiving an external pressure and from being bulged when receiving the coolant pressure.

By connecting these partitions, projections and ridges to ridges of flow passages formed in areas of the same plate member other than areas corresponding to the openings, it is possible to suppress the decrease in mechanical strength of the plate member due to the provision of the passage to a minimum, and suppress a pressure loss of coolant due to confluent and diffluent of passage to a minimum.

In particular, by forming grooves divided by the first ridges 30 at locations, corresponding to the inlet and output openings, in that face of the plate member formed with none of the inlet and outlet openings which is opposite to another face thereof serving as the outer face of the laminate, it is possible to increase the cross section of coolant flow passage to thereby reduce coolant pressure loss, with little decrease in mechanical strength.

In a cooling device in which a first plate member 2 disposed on one outermost side of a laminate is formed with an inlet opening for introducing coolant and an outlet opening for discharging the coolant and a second plate member 3 disposed on another outermost side of the laminate is formed with none of an inlet opening and an outlet opening, the provision of a flow passage, comprised of a through portion having partitions or projections and formed in the third or fourth and further plates disposed between the first and second plate members 2 and 3 at a location other than areas corresponding to the inlet and outlet openings so that the flow passage is joined to the plate member disposed adjacent thereto, makes it possible to increase the cross section of the coolant flow passage to thereby reduce the coolant pressure loss and to prevent the decrease in mechanical strength of the cooling device. By connecting these partitions and projections to ridges of the flow passage, it is possible to suppress the decrease in mechanical strength of the plate member due to the provision of the passage to a minimum, and suppress the pressure loss of coolant due to confluent and diffluent of passage to a minimum. To be noted, the passage comprised of the through portion separated by the partitions not only serves as a passage having a height but also has a function of being connected with a passage formed in a different plate member, thereby increasing the degree of freedom in passage structure design. As a result, the coolant pressure loss can largely be reduced, without causing the decrease in mechanical strength of the cooling device. As for passages formed in the respective plate members at locations other than the areas corresponding to the openings, they can have the same passage structure and the ridges, projections, and partitions of the plate members can be located at the same positions, whereby the mechanical strength can be further improved. Depending on plate members, the plate members can have the completely same construction, making it possible to suppress the increase in cost due to the increase in number of component parts.

Particularly in case that the semiconductor component to be cooled is an edge-emitting semiconductor device, it is necessary to mount the semiconductor component as closest as possible to one end of the cooling device. To cool the semiconductor component, the through holes provided close to the first side 10 of the plate members are required to be as closest as possible to the first side, and as a result, the mechanical strength is liable to decrease. By forming the through holes into a through hole array in which the through holes arranged in line and separated by partitions that are joined to ridges or partitions formed in the plate member adjacent thereto, it is possible to prevent the plate members near the first side from being deformed, whereby the mechanical strength of the cooling device can be improved.

Particular in a cooling device in which the outlet opening 6 is provided closer in position to the first side 10 of the plate members than the inlet opening 5 and in which the coolant supply passage is formed bypassing the outlet opening, the pressure loss of coolant can be reduced by forming part of the coolant supply passage, comprised of grooves shallower than the thickness of the plate members, in that face of the second plate member which is opposite to its another face serving as the outer face of the laminate, the second plate member being disposed on the side opposite to the first plate member formed with the inlet and outlet openings 5 and 6. By utilizing a passage comprised of a through portion separated by partitions for the third or fourth and further plate members disposed between the first and second plate members, the degree of freedom of passage structure design is increased without causing the decrease in mechanical strength, making it possible to form a passage having a large cross section, whereby the pressure loss of coolant can largely be reduced.

Particular in a cooling device in which the inlet opening 5 is provided closer in position to the first side 10 of the plate members than the outlet opening 6, the entire width of the coolant flow passage can be made broader to the extent that it is equal to or larger at any position than the diameter or equivalent width of at least either one of the inlet and outlet openings, making it possible to realize a cooling device which is low in coolant pressure loss and high in mechanical strength. Also in this case, by utilizing a passage comprised of a through portion separated by partitions for the third or fourth and further plate members disposed between the first and second plate members, it is possible to form passages in the respective plate members without causing the decrease in mechanical strength, making it possible to broaden the passage not only in the width direction thereof but also in the height direction thereof, whereby the passage having a large cross section can be formed to greatly reduce the pressure loss of coolant.

The pressure of coolant slightly varies depending on its flowing path, especially for the coolant having passed through the passage separated by the ridges or the partitions. When a coolant buffer is provided which is a through area extending over the entire width of the coolant supply passage, coolants having passed through different flow passages meet at the coolant buffer in which the coolant pressures are made equal, and the resultant coolant flow uniformly enters the through holes provided close to the first side of the plate members, whereby a semiconductor component, especially, a long semiconductor component such as a linear LD array, can uniformly be cooled.

In particular, even if the passage structure is made complicated in order to increase the mechanical strength and the cross section of passage, the increase in machining cost can be suppressed by forming the groove divided by ridges, the through portion separated by the partitions, and the opening having projections by means of chemical etching technique including half etching technique.

The plate members constituting the cooling device can be joined with high reliability, and the forming and joining of the plate members can be performed at low cost.

In particular, a cooling device having a high mechanical strength can be realized by joining and stacking the plate members together by means of diffusion welding. Alternatively, a method for joining and stacking the plate members together by forming a solder layer on joining faces of the plate members is advantageous in cost because the joining can be made at lower pressure and lower processing temperature as compared to diffusion welding. In addition, since the solder layer is formed on an inner wall face that defines a coolant flow passage, there is an advantage that wall erosion due to coolant can be prevented without making costly thick Au plating or the like.

Particularly when the plate members are joined by means of soldering, the ridges or partitions or projections in one plate member may be formed to nearly correspond in position to the ridges or partitions or projections in the adjacent plate member, so that a set of ones to be joined to each other may have different widths measured at their corresponding positions or are deviated in position from each other in a widthwise direction in a range smaller than their widths measured at their corresponding positions and that solder filets may be formed at their joined portions, to thereby increase the joining strength and prevent deformation of the plate members such as peeling-off thereof.

In particular, by using the plate members made of cupper or a cupper alloy which is high in coefficient of thermal conduction, a cooling device having high cooling performance can be realized. The plate members made of cupper or a cupper alloy can be diffusion welded, and can also be solder-joined when a solder layer is formed in joining faces. A metal film of Ni, Ti, Pt, Cr, or the like can be formed to provide a primary coating for the solder layer, whereby the formation of an intermetallic compound caused by excessive reaction between cupper and solder can be suppressed, and highly reliable solder joining can be achieved.

To be noted, in the cooling devices, the coolant flow passages such as the opening separated by projections or partitions, the groove separated by ridges, the through portion separated by projections or partitions, the through hole array, the through portion used to position the cooling device, the vacant space, which are to be formed in the plate members, and the outer shapes of the plate members can all be formed only by means of chemical etching technique including half etching technique, whereby the cooling device which is low in pressure loss of coolant and high in mechanical strength can be realized without increasing the machining cost. In particular, when all the formings of the plate members are performed only by means of half etching deeper than half the thickness of the plate member from one face of each plate member and half etching deeper than half the thickness of the plate members from another opposite face of each plate member, the machining cost can be reduced. Use of etching technique including the above-mentioned half etching technique makes it possible to suppress the increase in machining cost, even if the passage structure is made complicated as mentioned above. Particularly when all the formings of the plate members are performed only by means of half etching deeper than half the thickness of the plate member from one face of each plate member and half etching deeper than half the thickness of the plate member from another opposite plate member, as mentioned above, a large number of plate members can be fabricated from one sheet material at a time, and a large number of cooling devices can be fabricated at low cost.

By mounting a semiconductor laser serving as a semiconductor component to the cooling device which is, as mentioned above, high in mechanical strength and low in cost, and by bonding a thin metal sheet 43 with use of an insulating film 42 to thereby perform lead wiring, a high output, highly reliable, and highly accurate semiconductor laser device can be fabricated at low cost.

To be noted, since the mechanical strength near the first side 10 of the cooling device is improved, the through hole array 19 which is the coolant flow passage disposed closest to the first side 10 can be formed closer to the first side 10. Thus, even a surface-emitting semiconductor laser, which is mounted near the first side so that laser light can be emitted without being interrupted by the cooling device, can adequately be cooled, and thus high output and high reliability can be realized.

In particular, by making the entire width of the through hole array provided close to the first side of the plate members substantially equal to the width of a linear LD array, it is possible to allow laser emitters to be uniformly cooled and to exhibit uniform characteristics.

In particular, by mounting the semiconductor laser to the cooling device through a substrate 40 for semiconductor laser mounting that is formed at its surfaces with solder layers, it is possible to reduce residual stress due to difference between coefficients of thermal expansion of the semiconductor laser and the cooling device, whereby the reliability of the semiconductor laser device can be improved. By forming a recess or a groove 41 in at least either one of that joining face of the substrate for semiconductor laser mounting at which the substrate is joined to the cooling device and that mounting face of the cooling device on which the substrate for semiconductor laser mounting is mounted, and by forming a solder filet between the joining face of the substrate for semiconductor laser mounting and the mounting face of the cooling device, it is possible to further increase the joining strength between the substrate for semiconductor laser mounting and the cooling device, thus realizing a highly reliable semiconductor laser device.

In particular, the semiconductor laser device can be fabricated at low cost by bonding a thin metal sheet 43 having a thickness about 50 µm to the cooling device by use of an insulating film 42 whose opposite faces have an ability of adhesion, and by soldering the thin metal sheet to an electrode of the semiconductor laser having another electrode thereof provided in that face of the semiconductor laser at which the semiconductor laser is mounted to the cooling device to thereby perform wiring for electric current supply to the semiconductor laser. By using a double-sided adhesive thermosetting insulating film as the insulating film whose opposite faces have an ability of adhesion, the insulating film and the thin metal sheet can easily be aligned with the cooling deice since the double-sided adhesive thermosetting insulating film does not exhibit adhesiveness unless it is subject to temperature rise, whereby a highly accurate semiconductor laser device can be realized at low cost. By using the double-sided adhesive thermosetting insulating film having a structure that thermosetting adhesive layers are formed in opposite faces thereof and an insulating layer comprised of a resin layer or the like hardly softened when heated is disposed in a center thereof, problems of an overflowing of adhesive when heated and the like can be prevented, whereby the risk of an electrical short-circuit between the cooling device and the thin metal sheet can be reduced. By forming a resin layer of polyimide or the like in part of the thin metal sheet, the risk of an electrical short-circuit between the cooling device and the thin metal sheet can be further reduced.

In particular, by forming a slit 44 in or near those portions of the thin metal sheet 43 which are soldered to the electrode of the semiconductor laser, residual stress due to difference between coefficients of thermal expansion of the thin metal sheet and the semiconductor laser can be reduced, whereby the reliability of the semiconductor laser device can be improved. This is in particular effective for a case where the semiconductor laser is a linear LD array, so that there is a large area to which the thin metal sheet is soldered.

In particular, by forming the insulating film and the thin metal sheet with notches into which positioning guide pins are fitted, the insulating film and the thin metal sheet can be mounted to the cooling device with accuracy, and the semiconductor laser device can be fabricated with a high yield.

### BRIEF DESCRIPTION OF THE DRAWINGS

FIG. 1 is a perspective view showing a cooling device according to a first embodiment of the present invention;
FIG. 2 includes plan views showing plate members before they are stacked together which are used for the cooling device according to the first embodiment of the present invention, where left-hand side views show patterns on upper faces of the plate members, right-hand side views show patterns on lower faces (rear faces) of the plate members, and the plate members are arranged in stacking order;
FIGS. 3a and 3b each schematically shows a cross section of the cooling device of FIG. 1, where FIG. 3 a is a sectional view showing the plate members before they are joined together, and FIG. 3b is a sectional view showing them after joined;
FIG. 4 is a view for explaining a second embodiment of the present invention, in which an example of a pattern of vacant spaces is shown;
FIG. 5a is a view for explaining a third embodiment;
FIG. 5b is a view for explaining a modification of the one shown in FIG. 5a;
FIG. 6 is a perspective view showing a cooling device according to a fourth embodiment of the present invention;
FIG. 7 includes plan views showing plate members before they are stacked together which are used for the cooling device according to the fourth embodiment of the present invention, where left-hand side views show patterns on upper faces of the plate members, right-hand side views show patterns on lower faces (rear faces) of the plate members, and the plate members are arranged in stacking order;
FIG. 8 includes views for explaining a fifth embodiment of the present invention in which, among plate members used for a cooling device, three uppermost plate members in the stacking order are shown in plain views in a state before they are stacked, and in these plain views, left-hand side views and right-hand side views show patterns on upper faces and on lower faces (rear faces) of the plate members, respectively;
FIG. 9 includes further views for explaining the fifth embodiment of the present invention in which, among plate members used for the cooling device, fourth and fifth uppermost plate members in the stacking order are shown in plain views in a state before they are stacked, and in these plain views, left-hand side views and right-hand side views show patterns on upper faces and on lower faces (rear faces) of the plate members, respectively;
FIG. 10a is a view for explaining a sixth embodiment of the present invention, where part of a cooling device is shown in a plain view in case that at least one set of first through third ridges, first through fourth partitions, or first or second projections, which are joined to one another, have different widths measured at their corresponding positions;
FIG. 10b shows a case where the at least one set of first through third ridges, first through fourth partitions, or first or second projections, which are joined to one another, are deviated in position from one another in a range smaller than their widths measured at their corresponding positions;
FIGS. 11a-11c are views for explaining a seventh embodiment of the present invention, where FIG. 11a is a plain view showing a semiconductor laser device seen from above, which is comprised of a cooling device and a semiconductor laser mounted thereon, and FIGS. 11b and 11c are side views seen from left and beneath, respectively, in the plain view;
FIG. 12 is a perspective view showing a cooling device according to one prior art;
FIG. 13 includes plain views showing plate members used for the cooling device shown in FIG. 12, in a state before they are stacked together and in which the plate members are arranged in the stacking order ;
FIG. 14 is a perspective view showing a cooling device according to another prior art; and
FIG. 15 includes plain views showing plate members used for the cooling device shown in FIG. 14, in a state before they are stacked together and in which the plate members are arranged in the stacking order.

### DETAILED DESCRIPTION

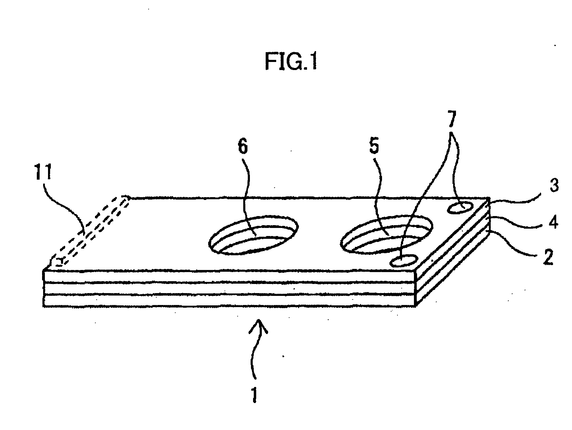

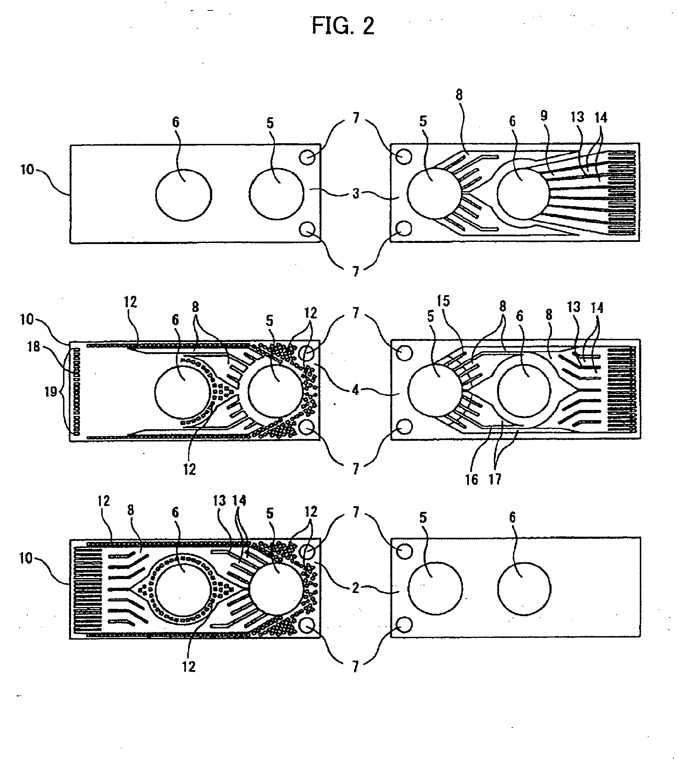

FIGS. 1 and 2 are views for explaining a first embodiment of the present invention. A cooling device 1 according to the first embodiment is shown in perspective view in FIG. 1, and plate members used in the cooling device 1 are shown in plan views in FIG. 2. In these plan views, the left-hand side views show upper faces of the plate members and the right-hand side views show lower faces (rear faces) of these plate members, respectively. The plate members are arranged in stacking order and formed at their surfaces with solder layers. As shown in these drawings, in this embodiment, the cooling device is constituted by a laminate of first, second and third plate members 2-4 each formed with an inlet opening 5 extending through the plate member for introducing coolant, an outlet opening 6 extending through the plate member for discharging the coolant, and a through portion 7 used for positioning the cooling device. The first through third plate members are each formed with a coolant supply passage 8, and the second plate member is formed with a coolant discharge passage 9. Furthermore, a through portion is formed near a first side 10 of the third plate member. In this embodiment, a semiconductor component to be cooled is a linear LD array 11, which is mounted to an outer face of the cooling device 1 near the first side 10. One of opposed joining faces of the adjacent plate members (specifically, the upper face of the first plate member out of the upper face of the first plate member and the lower face of the third plate member; and the upper face of the third plate member out of the lower face of the second plate member and the upper face of the third plate member) is formed with vacant spaces 12 each comprised of a recess, a groove, or a through portion, which is other than the inlet opening 5, the outlet opening 6, a coolant passage, and the through portion 7 used for the positioning of the cooling device. When the plate members stacked together is subject to temperature rise while being applied with a pressure, solder on the solder layers melts, and the molten solder gathers into the vacant spaces 12. As a result, solder filets are formed between the opposed joining faces of the adjacent plate members, whereby the joining strength of the plate members is increased.

Referring to FIG. 2, the first and second plate members 2, 3 are each formed with a flow passage comprised of a plurality of grooves 14 that are shallower than the thickness of the plate members and divided by second ridges 13. The third plate member is formed with a flow passage comprised of grooves 14 shallower than the thickness of the plate members and divided by second ridges 13, and is formed with a flow passage comprised of through portions having second projections 15 and through portions 17 separated by third partitions 16. Near the first side 10 of the third plate member, through holes are formed in the form of a through hole array 19 comprised of through holes arranged in line and separated by fourth partitions 18.

When the plate members stacked together is subject to temperature rise while being applied with pressure, solder on solder layers melts and the resultant molten solder gathers into the flow passages, whereby solder filets are formed between the opposed joining faces of the adjacent plate members. Such solder filets are formed at a relatively narrow spacing in the opposed joining faces one or both of which are formed with the flow passage having flow-passage dividing structures such as the second ridges 13, the second projections 15, the third partitions 16, or the fourth partitions 18.

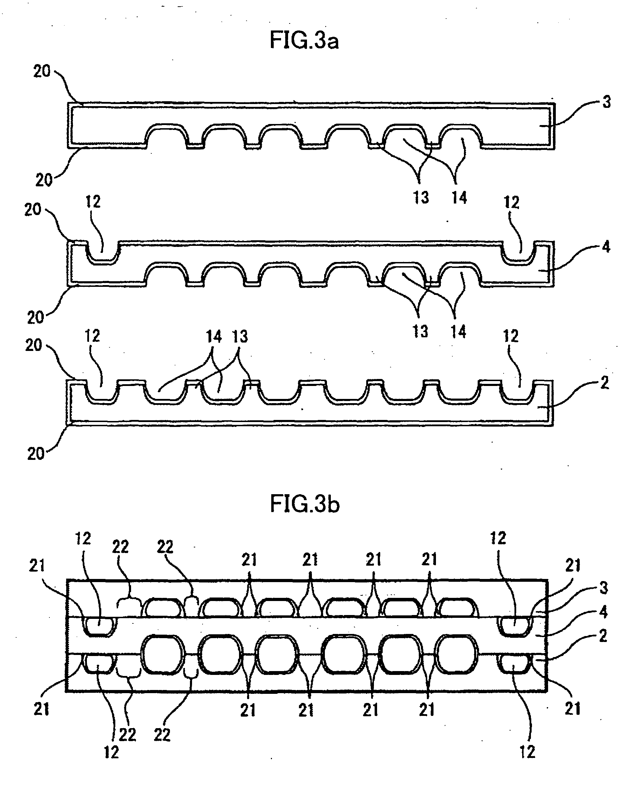

FIGS. 3a and 3b are views schematically showing the cross section of the cooling device of FIG. 1. The plate members having surfaces thereof formed with solder layers 20 are shown in FIG. 3a in a state before they are joined together and shown in FIG. 3a in a state after joined. As shown in these figures, the above-mentioned vacant spaces are formed in one of the opposed joining faces of the adjacent plate member in an area where the flow passage having passage-dividing structures is not provided, whereby solder filets 21 are formed at a relatively narrow spacing over the entirety of the joining faces. As a result, the joining areas 22 are made narrow at which the opposed joining faces are in close contact with each other only through the solder layer. Since the solder filets are formed at a relatively narrow spacing over the entire joining faces, the joining strength of the entirety of the plate members is uniformalized, whereby the plate members are hardly peeled off or the like.

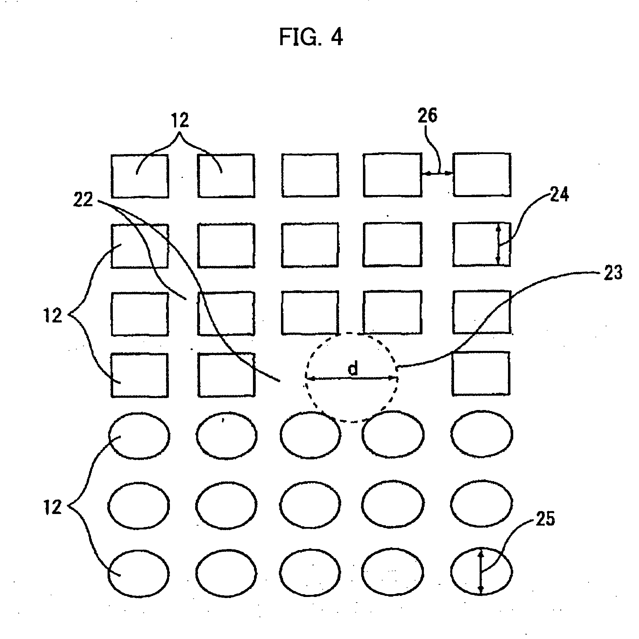

FIG. 4 is a view for explaining a second embodiment of the present invention defined in claims 4-6, in which an exemplified pattern of the aforementioned vacant spaces is shown. In FIG. 4, reference numeral 22 denotes joining areas at which the opposed joining faces are in close contact with each other only through the solder layer, and reference numeral 23 denotes the largest circle inscribed in the joining areas 22. The vacant spaces 12 are formed in such a manner that the diameter d of the largest circle is equal to or less than 3 mm, preferably equal to or less than 1mm. In addition, each vacant space 12 is formed such that a length 24 of a narrow side thereof or a shorter diameter 25 thereof is equal to or less than 1 mm, preferably about 0.3 mm. Furthermore, a spacing 26 equal to or less than 1 mm, preferably about 0.2 mm, is formed between adjacent vacant spaces. In this manner, by densely arranging the minute vacant spaces, the joining area 22 is made narrow at which the joining faces are closely contacted to each other solely through the solder layer, and the resultant solder filets can greatly increase the joining strength of the plate members.

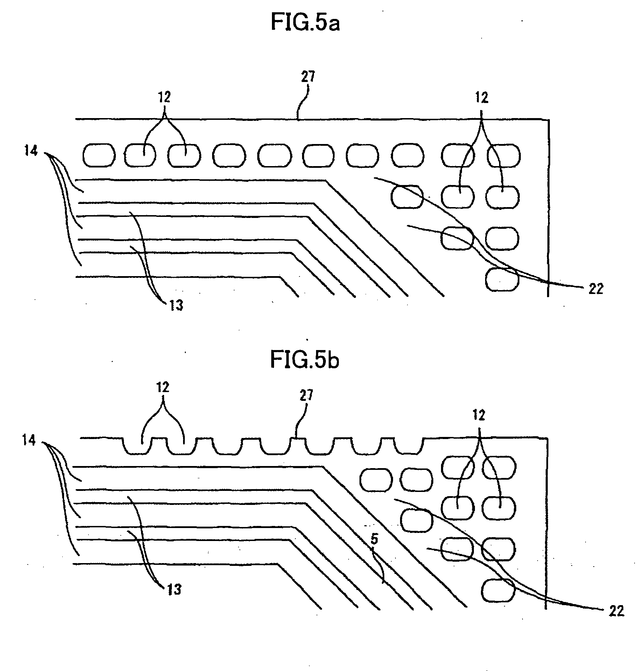

FIG. 5a is a view for explaining a third embodiment defined in claim 7, and FIG. 5b is a view for explaining a modification thereof defined in claim 8. In FIG. 5a, the vacant spaces are formed at locations invisible from outside after the plate members are stacked. In FIG. 5b, parts of the peripheries of the vacant spaces coincide with parts of the outer peripheries 27 of the plate members. By making parts of the peripheries of the vacant spaces coincide with part of the outer peripheries 27 of the plate members, it is possible to provide the vacant spaces even in such relatively narrow joining areas that are located near the outer peripheries of the plate members.

Meanwhile, the vacant spaces 12 can be formed by means of chemical etching technique including half etching technique which is low in machining cost.

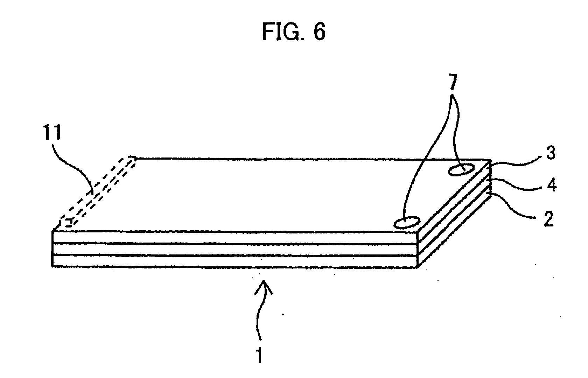

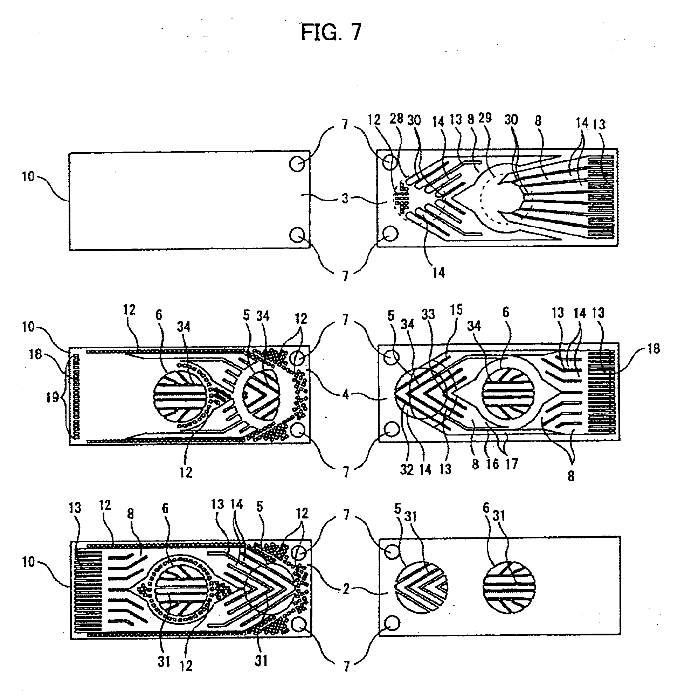

FIGS. 6 and 7 are views for explaining a fourth embodiment of the present invention. A cooling device 1 of the present invention is shown in perspective view in FIG. 6, and plate members used for the cooling device 1 before they are stacked are individually shown in plan views in FIG. 7. Among these plan views, the left-hand side views show patterns formed in upper faces of the plate members, and the right-hand side views show patterns formed in lower faces (rear faces) thereof. The plate members are arranged in stacking order. As shown in FIGS. 6 and 7, in this embodiment, the cooling device is comprised of a laminate of first, second and third plate members 2, 3 and 4. The first plate member 2 disposed on one outermost side of the laminate is formed with an inlet opening 5 extending through the first plate member for introducing coolant, and an outlet opening 6 extending through the first plate member for discharging the coolant. The second plate member 3 disposed on another outermost side is provided with none of inlet and outlet openings 5, 6 extending therethrough. The third plate member 4 disposed between the first and second plate members 2 and 3 is formed with an inlet opening 5 extending therethrough at part of an area 28 thereof corresponding to the inlet opening 5 formed in the first plate member, and formed with an outlet opening 6 extending therethrough at an area 29 thereof corresponding to the outlet opening 6 formed in the first plate member. The first through third plate member are each formed with a coolant supply passage 8. The second plate member is formed with a coolant discharge passage 9. Further, a through hole array 19 comprised of a plurality of through holes arranged in line and separated by fourth partitions 18 is formed near the first side 10 of the third plate member. Instead of the through hole array 19, a slit formed with no fourth partitions 18 may be formed.

Coolant is introduced from the inlet openings 5 into the coolant supply passage 8, flows into the coolant discharge passage 9 via the through hole array 19, and is discharged to the outlet openings 6, thereby cooling a semiconductor component that is mounted to that part of an outer face of the laminate which corresponds in position to the through hole array 19 and that is thermally coupled to the laminate. In this embodiment, the semiconductor component to be cooled is a linear LD array 11.

In the embodiment of the present invention shown in FIGS. 6 and 7, grooves 14 are formed at parts of the areas 28, 29 of that face (lower face) of the second plate member 3 which is opposite to another face (upper face) thereof serving as an outer face of the laminate. The areas 28, 29 respectively correspond to the inlet and outlet openings, and the grooves 14 are divided by first ridges 30 and shallower than the thickness of the second plate member 3. The provision of the grooves 14 divided by the first ridges 30 formed in the second plate member 3 makes it possible to increase the cross section of the coolant flow passage, whereby a coolant pressure loss can be reduced, with little decrease in the mechanical strength at the areas 28, 29 of the second plate member 3 individually corresponding to the inlet and outlet openings.

In areas of the second plate member other than the areas 28, 29 corresponding to the inlet and outlet openings, there is formed a flow passage comprised of a plurality of grooves 14 that are shallower than the thickness of the plate member and divided by second ridges 13. The first ridges 30 formed in the second plate member are connected to the second ridges 13 formed in the second plate member. Since the first and second ridges are connected to each other, the mechanical strength can be increased, as compared to a case where these ridges are not connected, and the increase in coolant pressure loss due to confluent and diffluent of coolant flow can also be prevented.

In the embodiment of the present invention shown in FIGS. 6 and 7, each of the inlet and outlet openings 5, 6 of the first plate member 2 is separated by first partitions 31. Part of the first partitions 31 formed in the first plate member 2 is connected to corresponding one or ones of the second ridges 13 formed in the first plate member 2. Further, at part of the area 28 of the third plate member 4 corresponding to the inlet opening, there are formed the grooves 14 that are separated by third ridges 32 and shallower than the thickness of the third plate member. In the area 28 of the third plate member 4 corresponding to the inlet opening, there are mixedly present both an open area extending through the third plate member and first projections 33 which are protrusions of the third plate member and which are not open.

Furthermore, second partitions 34 dividing the open area extending through the plate member are formed in those areas 28 and 29 of the third plate member 4 which respectively correspond to the inlet and outlet openings.

In the embodiment of the present invention shown in FIGS. 6 and 7, the first ridges 30 provided at the areas 28, 29 of the second plate member 3, individually corresponding to the inlet and outlet openings, are formed at positions that correspond to parts of the first projections 33 and the second partitions 34 formed in the third plate member 4 disposed adjacent to the second plate member. By stacking these plate members together, the first ridges 30 are joined to the first projections 33 and the second partitions 34.

The first partitions 31 formed in the openings of the first plate member 2 are formed at positions corresponding to the first projections 33 and the second partitions 34 formed in the third plate member 4 disposed adjacent to the first plate member 2. By stacking these plate members together, the first partitions 31 are joined to the first projections 33 and the second partitions 34. Further, the first projections 33 and the second partitions 34 formed in the third plate member 4 are connected to the second ridges 13 formed in the same third plate member. In this manner, the structures for dividing the opening or the flow passage formed in the areas 28, 29 individually corresponding to the inlet and outlet openings are joined to the similar structures of the adjacent plate member. Thus, the plate members are hardly peeled off and hardly deformed sine these structures serve to support one another.

In the embodiment of the present invention shown in FIGS. 6 and 7, a flow passage comprised of a through portion 17 having second projections 15 and separated by third partition 16 is formed in that area of the third plate member 4 other than the areas 28, 29 corresponding to the inlet and outlet openings, in addition to the through hole array 19 provided close to the first side 10. Most of the second ridges 13, the second projections 15, and the third partitions 16, which divide the flow passage formed in the area other than areas 28, 29 corresponding to the inlet and outlet openings, are formed at positions where they are joined to the adjacent plate member. Thus, by stacking the plate members together, the mechanical strength is increased so that the plate members are hardly deformed.

In the embodiment of the present invention shown in FIGS. 6 and 7, the through holes provided close to the first side 10 of the third plate member 4 are formed into the through hole array 19 separated by the fourth partitions 18 which are formed so as to be joined to the second ridges 13 formed in the adjacent first and second plate members 2, 3. In addition, the fourth partitions 18 formed in the third plate member 4 are connected to the second ridges 13 formed in the same plate member, whereby the mechanical strength near the first side 10 is increased, and the thermal conduction between the plate members in the vicinity of the first side 10 is enhanced, thus improving the cooling performance of the cooling device.

In the embodiment of the present invention shown in FIGS. 6 and 7, the outlet openings 6 are provided closer in position to the first side 10 than the inlet openings 5. The resultant flow passage structure is such that coolant flowing into from the inlet openings 5 passes through the coolant supply passages 8 formed bypassing the outlet openings 6 of the first and third plate members 2 and 4, passes through the coolant discharge passage 9 of the second plate member 3 by way of the through hole array 19 formed in the third plate member 4 so as to be close to the first side 10, and is then discharged to the outlet openings 6. In addition, part of the coolant supply passages 8 comprised of grooves shallower than the thickness of the plate members is formed in the face of the second plate member 3 which is opposite to its another face serving as the outer face of the laminate: The provision of the coolant supply passage 8 in the second plate member 3 which is the plate member most away from the coolant inlet port makes it possible to broaden the cross section of the coolant supply passage 8 to thereby reduce a pressure loss of coolant, even though the coolant supply passage is formed bypassing the outlet openings 6. Since the first or second ridges are formed in the coolant supply passage 8 of the second plate member 3 so as to be joined to the third plate member 4, a reduction in mechanical strength can be prevented.

At locations relatively near the first side 10, the second ridges 13 constituting the coolant supply passage 8 of the first plate member 2 are formed at positions corresponding to the second ridges 13 constituting the coolant discharge passage 9 of the second plate member 3, whereby the mechanical strength at locations relatively near the first side 10 is increased. The flow passage located at those locations is finely divided by the second ridges 13 in order to increase the efficiency of heat exchange between the coolant and the plate members.

In a case where the cooling device 1 is fabricated by forming solder layers 20 on the surfaces of the plate members which are then solder-joined into the laminate, vacant spaces 12 may be formed in the joining faces of the plate members, as shown in FIG. 7.

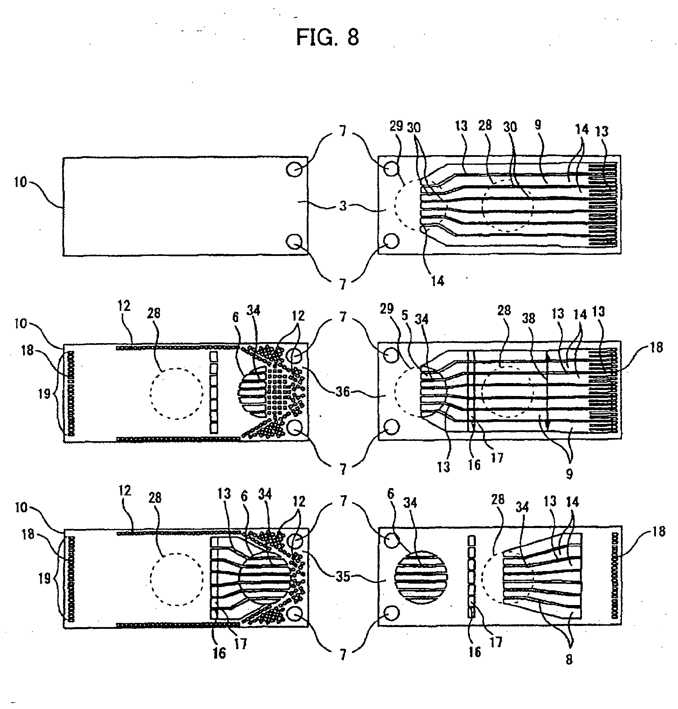

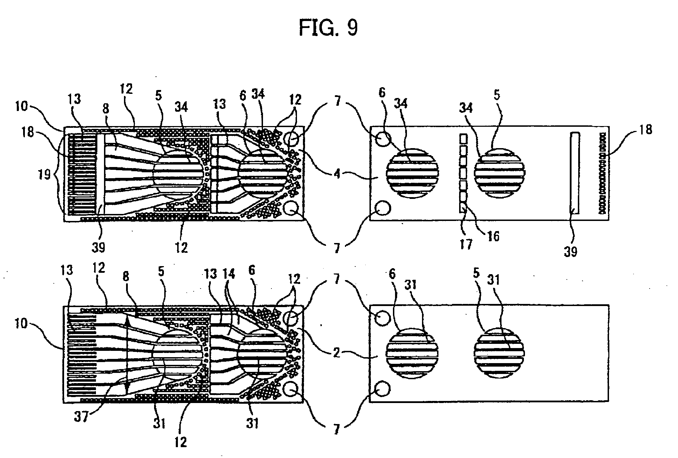

FIGS. 8, 9 are views for explaining a fifth embodiment of the present invention, in which plate members used for the cooling device 1 of the present invention are shown in plain views in a state before they are stacked together. Out of the plate members, the three uppermost plate members in the stacking order are shown in FIG. 8 in a state before they are stacked together, and the forth and fifth uppermost plate members in the stacking order are shown in FIG. 9. In these drawings, left-hand views show patterns on upper faces of the plate members, and right-hand views show patterns on lower faces (rear faces) of the plate members.

As shown in FIGS. 8 and 9, in this embodiment, the cooling device 1 is comprised of a laminate of the five plate members. The first plate member 2 which is disposed on one outermost side of the laminate is formed with an inlet opening 5 extending through this plate member for introducing coolant, and an outlet opening 6 extending therethrough for discharging the coolant. On the other hand, the second plate member 3 which is disposed on another outermost side is provided with none of the inlet and outlet openings 5, 6 extending therethrough.

Between the first and second plate members 2 and 3, there are disposed the third, forth and fifth plate members 4, 35 and 36. Second partitions 34 formed in each of the third through fifth plate members are formed so as to correspond in position to the second partitions 34 formed in the adjacent plate member. Thus, by stacking these plate members together, the second partitions 34 of each plate member are joined to those formed in another plate member disposed adjacent to the plate member. Since adjacent ones of the second partitions 34 formed in the inlet or outlet opening 5 or 6 of the third to fifth plate members are joined to one another, not only the mechanical strength of the second partitions 34 is increased, but also the mechanical strength of the first partitions 31 and the first ridges 30 is increased which are respectively formed in the first and second plate members 2, 3 and which are connected to the second partitions 34 that are joined together and increased in strength, whereby a deformation hardly occurs.

The third through fifth plate members each have those areas, other than the areas 28, 29 individually corresponding to the inlet and outlet openings, which are formed with no only the through hole array 19 provided close to the first side 10 but also a flow passage comprised of a through portion 17 separated by third partitions 16. Most of second ridges 13 and third partitions 16, which divide flow passages formed in the areas other than the areas 28, 29 corresponding to the inlet and outlet openings, are formed at positions where they are joined to the adjacent plate member.

In the third through fifth plate members, through holes provided close to the first side 10 are formed into a through hole array 19 separated by fourth partitions 18. These fourth partitions 18 of each of the third through fifth plate members are formed so as to be joined to the fourth partitions 18 of adjacent another plate member, and the fourth partitions 18 of the third and fifth plate member 4, 36 are connected to the second ridges 13 which are formed in the same plate members, respectively. As a result, the flow of coolant is smoothened whereby the increase in pressure loss is suppressed, and the mechanical strength near the first side 10 is advantageously increased. Further, the thermal conduction between the plate members is enhanced in the vicinity of the first side 10, thus improving the cooling performance of the cooling device.

In the embodiment of the present invention shown in FIGS. 8 and 9, the inlet openings 5 are provided closer in position to the first side 10 than the outlet openings 6. The flow passage structure is such that coolant flowing into from the inlet openings 5 passes through the coolant supply passages 8 formed in the first plate member 2 and in the third and fourth plate members, passes through the coolant discharge passage 9 formed in at least either one of the second and fifth plate members 3, 36 by way of the through hole array 19 formed in the third through fifth plate member 4 so as to be close to the first side 10, and is then discharged to the outlet openings 6. In addition, the entire width 37 of the coolant supply passage including the second ridges 13 and the groove 14 separated by these second ridges, the entire width 38 of the coolant discharge passage, and the entire width 38 of the coolant discharge passage including the third partitions 16 and the through portion 17 separated by these third partitions 16 are each broader at any position than the diameter of the inlet or outlet opening 5 or 6. Except for in the vicinity of the inlet or outlet opening 5 or 6, these widths are equal to or larger than 70% of the corresponding width of the plate members. This is because the flow passages are formed so as not to bypass the openings. The provision of the flow passages, divided by the second ridges 13 and formed in the areas 28, 29 of the second plate member corresponding to the inlet and outlet openings, makes it possible to ensure a broad cross sectional area of flow passage to thereby reduce a pressure loss of coolant without causing a reduction in mechanical strength.

At locations relatively near the first side 10, the second ridges 13 constituting the coolant supply passage 8 of the first plate member 2 are formed at positions corresponding to the second ridges 13 constituting the coolant discharge passage 9 of the second plate member 3, whereby the mechanical strength at locations relatively near the first side 10 is increased. The flow passage located at those locations is finely divided by the second ridges 13 in order to increase the efficiency of heat exchange between the coolant and the plate members, as mentioned above.

In the embodiment of the present invention shown in FIGS. 8 and 9, most of the flow passage structure of the first plate member 2 is the same as that of the third plate member 4 disposed closer to the first plate member than to the center of the laminate, and the second plate member 3 has substantially the same as that of the fifth plate member 36 disposed closer to the second plate member than to the laminate center. The fact that plate members have the same flow passage structure indicates that the ridges and the partitions are disposed at the same positions. Thus, the plate members have an increased mechanical strength when joined together, and are hardly deformed.

In FIGS. 8 and 9, one or more plate members having completely the same structure as that of the third plate member 4 may be added between the first and fourth plate members 2, 35, and one or more plate members having completely the same structure as that of the fifth plate member 36 may be added between the second and fourth plate members 3, 35. When one or more plate members are added, the thickness of the cooling device 1 increases, but the cross section of flow passage can be increased to reduce the pressure loss of coolant. In other words, the pressure loss of coolant can be reduced to the desired level by adjusting the number of plate members to be added. In this case, the number of plate members used increases. However, one or more plate members to be added have completely the same structure of the existing plate members, and therefore, the number of component types does not increase, making it possible to suppress the increase in cost to a minimum.

In the embodiment of the present invention shown in FIGS. 8 and 9, the third plate member 4 disposed closer to the first plate member than to the laminate center is provided with a coolant buffer 39 at a location closer to the center of the third plate member than to the through hole array 19 provided close to the first side 10, wherein the coolant buffer 39 is a through area extending over the entire width 37 of the coolant supply passage. Coolants having passed through different flow passages meet at the buffer 39, whereby the coolant pressures are made equal, and the resultant coolant flow uniformly enters the through hole array 19 so that the linear LD array is uniformly cooled. In this embodiment, the buffer 39 is provided in the coolant supply passage 8. Alternatively, in order to uniformalize the back pressure for the coolant flowing into the through hole array 19, the buffer 39 may be provided in the coolant discharge passage 9.

Meanwhile, the grooves divided by the first through third ridges, the openings separated by the first or second partitions, the through portion 17 separated by the third partitions 16, the through hole array 19 provided close to the first side 10, the opening having the first projections 33, and the through portion having the second projections 15 can be formed by means of chemical etching technique including half etching technique which is low in machining cost.

The plate members shown in FIGS. 6, 7 or FIGS. 8, 9 can be stacked together by joining them by means of diffusion welding. Alternatively, they may be stacked by means of soldering after forming solder layers on the joining faces of the plate members.

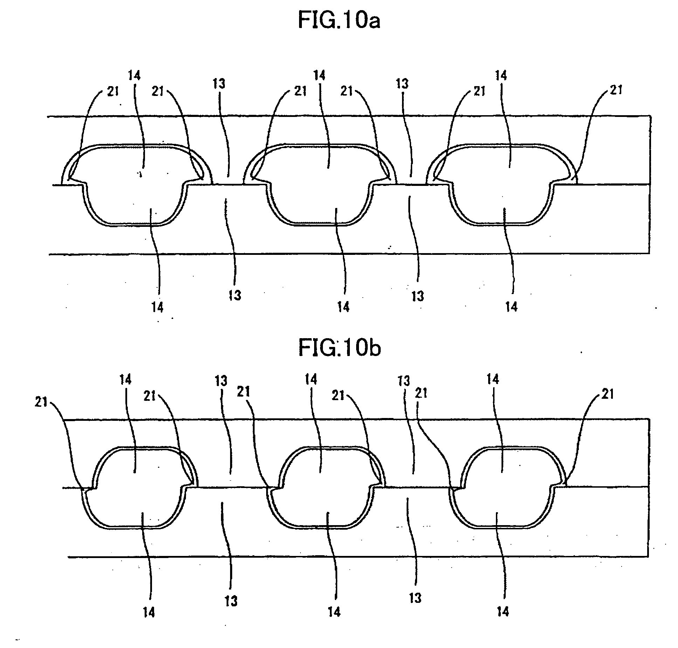

FIGS. 10a and 10b are views for explaining a sixth embodiment of the present invention, in which a cooling device 1, comprised of a laminate stacked by soldering plate members whose joining faces are formed with solder layers 20, is partly shown in cross sectional views. Each plate member has first to third ridges, first to fourth partitions, or first or second projections. At least part of these ridges, partitions or projections is so formed as to nearly correspond in position to first to third ridges, first to fourth partitions, or first or second projections of the adjacent plate member. Corresponding ones of the ridges, partitions or projections are joined.

FIG. 10a shows a case where at least one set of the first to third ridges, the first to fourth partitions, or the first or second projections, which are joined to each other, have different widths that are measured at their corresponding positions. FIG. 10b shows a case where at least one set of the first to third ridges, the first to fourth partitions, or the first or second projections, which are joined to each other, are deviated in position from one another in the widthwise direction in a range smaller than widths of the ridges, partitions, or projections measured at their corresponding positions.

In FIG. 10, an example is shown where the second ridges 13 formed in a plate member are joined to the second ridges 13 formed in the adjacent plate member. With this structure, as shown in FIG. 10, solder filets 21 are formed at solder-joined portions of these plate members, making it possible to increase the joining strength.

The plate members can be made of cupper or a cupper alloy which is high in coefficient of thermal conduction. In the case of solder-joined plate members having joining faces formed with solder layers 20, solder used for the solder layers can be made of a material selected from a group including Sn having a relatively low melting point, a eutectic binary or more complex Sn-based alloy, In, a binary or more complex In-based alloy, Ni, and a binary or more complex Ni-based alloy. The solder layer may be formed by means of vapor deposition or plating.

Depending on materials used for the solder layer and the plate members, the formation of an intermetallic compound advances after solder-joining process, thus decreasing the joining strength with elapse of time. To obviate this, a film of Ni, Ti, Pt, Cr, or the like may be formed to provide a primary coating for the solder layer 20.

Meanwhile, the inlet openings 5, the outlet openings 6, the groove separated by the first ridges 30, the through portion separated by the first partitions 31, the through portion having the first projections 33 or the through portion separated by the second partitions 34, the groove separated by the third ridges 32, the groove 14 separated by the second ridges 13 or the through portion 17 having the second projections 15 or the through portion 17 separated by the third partitions 16, the through hole array 19 separated by the fourth partitions 18 provided close to the first side 10, the through portion 7 used to position the cooling device, the vacant spaces 12, the plate members including their outer shapes can be formed only by means of chemical etching technique including half etching technique which is low in machining cost.

The inlet openings 5, the outlet openings 6, the groove separated by the first ridges 30, the through portion separated by the first partitions 31, the through portion having the first projections 33 or the through portion separated by the second partitions 34, the groove separated by the third ridges 32, the groove 14 separated by the second ridges 13 or the through portion 17 having the second projections 15 or the through portion 17 separated by the third partitions 16, the through hole array 19 separated by the fourth partitions 18 provided close to the first side 10, the through portion 7 used to position the cooling device, the vacant spaces 12, the plate members including their outer shapes can be formed only by means of half etching deeper than half the thickness of the plate member from one face of each plate member and half etching deeper than half the thickness of the plate member from another opposite plate member. By forming all the portions of the plate members by means of the just-mentioned method, a large number of plate members can be fabricated from one sheet material at a time.

In particular, a large number of cooling devices can be fabricated at extremely low costs by machining a raw sheet material into a semi-finished product having a large number of plate members connected to one another through narrow bridges, and by cutting the semi-finished product so as to separate plate members from bridges after the corresponding plate members are stacked and joined together. This method makes it possible to fabricate the cooling device while suppressing costs, even if the aforementioned complicated flow passage structure is adopted in order to increase the mechanical strength of the cooling device and reduce the pressure loss of coolant.

In order to perform the forming by means of ordinary isotropic chemical etching as mentioned above, it is preferable that the grooves divided by the first to third ridges, the through portions having the first and second projections, or the through portions separated by the first to fourth partitions have their widths slightly larger than the thickness of the plate member. In order to prevent the decrease in mechanical strength, these widths should be suppressed to be equal to or less than five times the thickness of plate member. From the viewpoint of preventing the decrease in cross section of flow passage, it is desired to make the widths of the first to third ridges, the first and second projections, and the first to fourth partitions narrower. On the other hand, to ensure the mechanical strength, it is preferable that the widths are about 0.5-3 times the thickness of plate member. The thinner the plate member thickness, the more minute flow passage can be formed, but a much larger number of plate members is required to obtain the required cross section of flow passage, resulting in increased cost. In view of this, the thickness of plate member is preferably within a range from about 0.2 mm to about 0.4 mm.

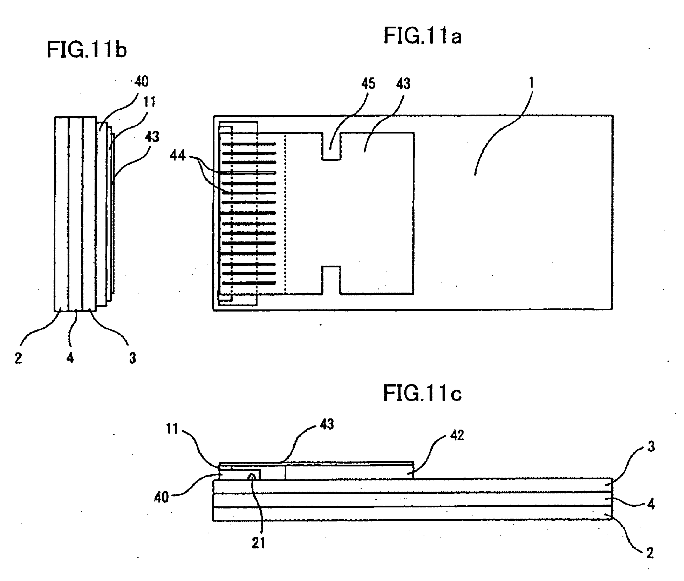

FIGS. 11a-11c are views for explaining a seventh embodiment of the present invention. FIG. 11a is a plan view of a semiconductor laser system as seen from above in which a semiconductor laser is mounted to a cooling device of the present invention, and FIGS. 11b and 11c are side views as seen from left and beneath in the plan view, respectively.

The semiconductor laser used here is an edge-emitting semiconductor laser, more specifically, a monolithic linear LD array 11 in which a laser emitter is provided in plural numbers. The linear LD array 11 is mounted near the first side 10 of the cooling device in a direction parallel to the first side, so that the emitted laser light can be taken out to the outside, without being interrupted by the cooling device 1.

Although no illustrations are given in FIG. 11, the entire width of the through hole array 19 provided close to the first side of a plate member, including forth partitions 19, is designed to be substantially the same as the width (length) of the linear LD array 11, whereby the linear LD array 11 can be uniformly cooled. The width (length) of the linear LD array 11 is ordinarily about 10 mm.

The linear LD array 11 may be directly mounted to the cooling device 1. In this embodiment, however, the linear LD array is mounted thereto through a substrate 40 for semiconductor laser mounting in order to reduce residual stress appearing after the linear LD array being mounted due to difference between coefficients of thermal expansion of the linear LD array and the cooling device. For example, solder layers may be formed in the linear LD array (semiconductor laser) mounting face of the substrate 40 for semiconductor laser mounting and a joining face thereof at which the substrate 40 is joined to the cooling device. The linear LD array is then subject to temperature rise in vacuum or in a reducing atmosphere, whereby the linear LD array 11 can be mounted to the cooling device 1. In order to reduce residual stress, the solder layer is preferably made of a material which is relatively low in melting point. The substrate 40 for semiconductor laser mounting has a face thereof located on the side of laser light emission, which face is preferably disposed slightly behind a face of the cooling device 1 on the side of laser light emission. Preferably, the linear LD array 11 is arranged such that a distance between the laser light emitting face and the face of the substrate 40 for semiconductor laser mounting on the side of laser light emission is equal to or less than 50 µm, for instance.

In order to increase the joining strength between the cooling device 1 and the substrate 40 for semiconductor laser mounting, recesses or grooves 41 may be formed in the mounting face of the cooling device 1 used to mount the substrate 40 for semiconductor laser mounting, and solder filets 21 may be formed between the joining face, at which the substrate 40 is joined to the cooling device, of the substrate 40 for semiconductor laser mounting and the mounting face of the cooling device 1 used to mount the substrate 40 for semiconductor laser mounting. Instead of forming the recesses or grooves in the mounting face of the cooling device 1 used to mount the substrate 40 for semiconductor laser mounting, such recesses or grooves may be formed in the joining face, at which the substrate 40 is joined to the cooling device, of the substrate 40 for semiconductor laser mounting. Solder filets may be formed between the joining face, at which the substrate 40 is joined to the cooling device, of the substrate 40 for semiconductor laser mounting and the mounting face of the cooling device 1 used to mount the substrate 40 for semiconductor laser mounting.

Using an insulating film 42 whose opposite faces have the ability of adhesion, a thin metal sheet 43 of about 50 µm in thickness having a portion thereof formed with a solder layer is bonded to the outer face of the cooling device to which the semiconductor laser is to be mounted. The thin metal sheet is then soldered to an electrode of the semiconductor laser 11, which has another electrode thereof provided in the face of the semiconductor laser used to mount the semiconductor laser to the cooling device 1 or the substrate 40 for semiconductor laser mounting, whereby wiring used for electric current supply to the semiconductor laser 11 is performed. As the insulating film 42, a double-sided adhesive thermosetting insulating film may be used, which is softened and exhibits adhesiveness when heated. The double-sided adhesive thermosetting insulating film does not exhibit adhesiveness unless it is subject to temperature rise, making it easy to align the insulating film and the thin metal sheet.

There may be used a double-sided adhesive thermosetting insulating film having such a structure that thermosetting adhesive layers are formed in opposite faces of the film, and an insulating layer comprised of a resin layer or the like hardly softened even when heated is disposed in the center of the film, in order to prevent a problem of an overflowing of adhesive beyond the thin metal sheet 43 when heated, etc., thereby reducing the risk of an electrical short-circuit between the cooling device 1 and the thin metal sheet 43. In order to reduce the risk of short-circuit between the cooling device 1 and the thin metal sheet 43, a resin layer of polyimide or the like may be formed in the face of the thin metal sheet 43 on the side close to the cooling device except for those portions of the sheet and vicinity which are soldered to the semiconductor laser 11.

Slits 44 may be formed in or near the portions of the thin metal sheet 43 which are soldered to the electrode of the semiconductor laser 11, so as to reduce residual stress due to a difference between coefficients of thermal expansion of the thin metal sheet 43 and the semiconductor laser 11. As shown in FIG. 11, the slits 44 may be formed into a shape in which slits extending to the periphery of the thin metal sheet 43 and slits extending short of the periphery of the thin metal sheet 43 are mixedly present, or a shape in which all the slits extend to the periphery of the thin metal sheet 43. Preferably, the width of each slit be about 1.5 to 5 times the thickness of the thin metal sheet 43 and the pitch of the slits be equal to or less than 1 mm, so that the slits may be formed by means of chemical etching.

The insulating film 42 and the thin metal sheet 43 may be formed with notches 45 used to position the insulating film 42 and the thin metal sheet 43 relative to the cooling device 1 when the thin metal sheet 43 is bonded to the cooling device 1 through the insulating film 42. Although not illustrated, guide pins may be fitted into the notches 45 for performing the positioning for assembly. The shape of the notches 45 may be not only rectangular but also semicircular adapted to be fitted to a guide pin which is of rotational symmetry.

## Claims

1. A cooling device for a semiconductor component, comprising:
a laminate of at least three plate members stacked together, in which a passage for flowing coolant is formed in at least one of the plate members and a solder layer is formed on at least a joining face of at least one of the plate members which are joined and stacked together,
wherein one or more vacant spaces are formed on at least one of the joining face on which the solder layer is formed and a joining face of another plate member opposed to the joining face on which the solder layer is formed, said one or more vacant spaces being formed as recesses, grooves or through holes other than an inlet opening for introducing the coolant, an outlet opening for discharging the coolant, a groove or a through portion or a recess used as a coolant flow passage, and a through hole formed for positioning of the cooling device.

2. A cooling device according to claim 1, wherein a molten solder gathers into said vacant space, and a solder filet is formed between the joining faces.

3. A cooling device according to claim 1 or 2, wherein the solder layer is formed in all the joining faces of the plate members constituting the laminate, and said vacant space is formed in at least either one of every pair of the opposed joining faces.

4. A cooling device according to any one of claims 1-3, wherein:
every opposed joining faces have joining areas at which they are in close contact with each other only through the solder layer, each of the joining areas being formed with none of the vacant space, the inlet opening, the outlet opening, the groove or the through portion or the recess used as the coolant flow passage, and the through hole formed for positioning the cooling device, and
said joining area is narrow, and a circle inscribed in the joining area has a diameter equal to or less than 3 mm.

5. A cooling device according to any one of claims 1-4, wherein said at least one vacant space has a narrow side of a length equal to or less than 1 mm or a short diameter equal to or less than 1 mm.

6. A cooling device according to any one of claims 1-5, wherein the vacant space is provided in plural numbers, and a spacing between each vacant space and at least one adjacent vacant space is equal to or less than 1 mm.

7. A cooling device according to any one of claims 1-6, wherein said at least one vacant space is formed at a location invisible from outside after the plate members are stacked together.

8. A cooling device according to any one of claims 1-7, wherein at least part of periphery of said at least one vacant space is in coincidence with part of outer periphery of the plate members.

9. A cooling device according to any one of claims 1-8, wherein said at least one vacant space is formed by means of chemical etching technique including half etching technique.

10. A cooling device for a semiconductor component, comprising:
a laminate comprised of at least three plate members stacked together, in which at least one of the at least three plate members is formed with a passage through which coolant flows, and in which a first plate member disposed on one outermost side of the laminate is formed with an inlet opening extending through the first plate member for introducing the coolant and an outlet opening extending therethrough for discharging the coolant,
wherein a second plate member disposed on another outermost side of the laminate is formed with none of an inlet opening and an outlet opening extending therethrough,
a third or fourth plate member and a further plate member are disposed between said first and second plate members, said third or fourth and further plate members being formed with an opening that extends therethrough and a through hole that is formed closely to a first side of the plate members, the opening being either one of inlet and outlet openings individually corresponding in position to the inlet and outlet openings formed in said first plate member, so that the coolant is introduced from the inlet opening into a coolant supply passage formed in any one of the plate members, flows into a coolant discharge passage formed in any one of the plate members via the through hole, and is discharged to the outlet opening, thereby cooling a semiconductor component that is mounted on an outer face of the laminate near a position corresponding to the through hole so as to be thermally coupled to the laminate, and
a groove divided by one or more first ridges and shallower than a thickness of said second plate member is formed in at least part of at least either one of those areas of a face of said second plate member on a side opposite to the outer face of the laminate which respectively correspond to the inlet and outlet openings.

11. A cooling device according to claim 10, wherein a passage comprised of a plurality of grooves that are divided by one or more second ridges and shallower than a thickness of the plate members is formed in at least part of that area of the plate member which is other than the areas respectively corresponding to the inlet and outlet openings, and
at least one of the one or more first ridges formed in said second plate member is connected to the one or more second ridges formed in said second plate member.

12. A cooling device for a semiconductor component, comprising:
a laminate comprised of at least three plate members stacked together, in which a passage through which coolant flows is formed in at least one of said at least three plate members, and in which a first plate member disposed on one outermost side of said laminate is formed with an inlet opening extending through the first plate member for introducing the coolant and an outlet opening extending therethrough for discharging the coolant,
wherein a second plate member disposed on another outermost side of said laminate is formed with none of an inlet opening and an outlet opening extending therethrough,
a third or fourth plate member and a further plate member are disposed between said first and second plate members, said third or fourth and further plate members being formed with an opening that extends therethrough and a through hole that is formed closely to a first side of the plate members, the opening being either one of inlet and outlet openings individually corresponding in position to the inlet and outlet openings formed in said first plate member,
the coolant is introduced from the inlet opening into a coolant supply passage formed in any one of the plate members, flows into a coolant discharge passage formed in any one of the plate members via the through hole, and is discharged to the outlet opening, thereby cooling a semiconductor component that is mounted on an outer face of the laminate near a position corresponding to the through hole so as to be thermally coupled to the laminate, and
at least part of either one of the inlet and outlet openings of said first plate member is separated by first partitions.

13. A cooling device according to claim 12, wherein at least one of the first partitions formed in said first plate member is connected to a corresponding one or more second ridges formed in said first plate member.

14. A cooling device according to any one of claims 10-13, wherein a groove separated by third ridges and shallower than a thickness of the plate members is formed in at least part of at least either one of those areas of said third or fourth and further plate members which respectively correspond to the inlet and outlet openings.

15. A cooling device according to any one of claims 10-14, wherein an open area that extends through said third or fourth and further plate members and those one or more first projections which are not open and which are protrusions of these plate members are mixedly present in at least either one of those areas of said third or fourth and further plate members which respectively correspond to the inlet and outlet openings.

16. A cooling device according to claim 15, where at least one of said one or more first projections, formed in that area of said third or fourth and further plate members which corresponds to the opening, is formed into a shape having opposite ends connected to a corresponding one or ones of these plate members, and serves as second partitions by which said open area extending through said third or fourth and further plate members is separated.

17. A cooling device according to claim 16, wherein at least part of said one or more first ridges, formed in that area of said second plate member which corresponds to the opening, is formed at a position corresponding to at least part of said one or more first projections or said second partitions or said third ridges that are formed in said third or fourth and further plate members adjacent to said second plate member, and
at least part of said one or more first ridges is joined to at least part of said one or more first projections or said second partitions or said third ridges.

18. A cooling device according to claim 16, wherein at least part of said one or more first partitions, formed in that area of said first plate member which corresponds to the opening, is formed at a position corresponding to at least part of said one or more first projections or said second partitions or said third ridges that are formed in said third or fourth and further plate members adjacent to said first plate member, and
at least part of said one or more first partitions is joined to at least part of said one or more first projections or said second partitions or said third ridges.

19. A cooling device according to any one of claims 16-18, wherein at least said one or more first projections or said second partitions or said third ridges that are formed in said third or fourth and further plate members are connected to said one or more second ridges that are formed in the same plate members.

20. A cooling device according to any one of claims 16-19, wherein a plurality of plate members including said third or fourth and further plate members are disposed between said first and second plate members,
at least part of said first projections or said second partitions or said third ridges formed in one of said third or fourth and further plate members is formed to correspond in position to said first projection or said second partitions or said third ridges formed in another plate member adjacent to said one of the third or fourth and further plate members, and is joined to said first projection or said second partitions or said third ridges formed in said another plate member.

21. A cooling device according to any one of claims 10-20, wherein a flow passage comprised of a through portion having second proj ections or a through portion separated by third partitions is formed in at least part of an area that is other than those areas of said third or fourth and further plate members which individually correspond to the inlet and outlet openings, in addition to said through holes provided close to the first side of the plate members.

22. A cooling device according to claim 21, wherein at least part of said second ridges or said second projections or said third partitions is joined to the plate member disposed adjacent thereto.

23. A cooling device according to any one of claims 10-22, wherein said through holes provided close to the first side of said third or fourth and further plate members are a through hole array in which a plurality of through holes arranged in line and separated by fourth partitions.

24. A cooling device according to claim 23, wherein at least part of said fourth partitions formed in said third or fourth and further plate members is joined to said second ridges or the fourth partitions of the plate member disposed adjacent thereto.

25. A cooling device according to claim 23 or 24, wherein said fourth partitions formed in said third or fourth and further plate members are connected to said second ridges formed in the same plate members.

26. A cooling device according to any one of claims 10-25, wherein said cooling device comprises a flow passage structure in which said outlet opening is provided closer in position to the first side of the plate members than said inlet opening, the coolant flowing into from said inlet openings passes through said coolant supply passage formed in at least either one of said first plate member and that one of said third or fourth and further plate members which is disposed adjacent to said first plate member so as to bypass said outlet opening, passes through the coolant discharge passage formed in at least either one of said second plate member and that one of said third or fourth and further plate members which is disposed adjacent to said second plate member by way of the through holes formed in said third or fourth and further plate members so as to be close to the first side of the plate members, and is then discharged to said outlet opening, and
part of the coolant supply passage comprised of grooves shallower than the thickness of the plate members is formed in the face of said second plate member which is opposite to its another face serving as the outer face of the laminate.

27. A cooling device according to any one of claims 21-25, wherein said cooling device comprises a flow passage structure in which said inlet opening is provided closer in position to the first side of the plate members than said outlet opening, the coolant flowing into from said inlet opening passes through said coolant supply passage formed in at least either one of said first plate member and that one of said the third or fourth and further plate members which is disposed adjacent to said first plate member, passes through said coolant discharge passage formed in at least either one of said second plate member and that one of said third or fourth and further plate members which is disposed adjacent to said second plate member by way of the through holes formed in said third or fourth and further plate members so as to be close to the first side of the plate members, and is then discharged to said outlet opening, and
an entire width of the coolant supply passage or the coolant discharge passage including the second ridges and the groove separated by the second ridges, or an entire width of the coolant supply passage or the coolant discharge passage including the second projections and the through portion having the second projections, or an entire width of the coolant supply passage or the coolant discharge passage including the third partitions and the through portion separated by the third partitions is equal to or broader at any position than the diameter or equivalent width of the inlet or outlet opening.

28. A cooling device according to any one of claims 21-27, wherein at least part of said second ridges or said third partitions constituting the coolant supply passage is formed at a position corresponding to said second ridges or said third partitions constituting the coolant discharge passage.

29. A cooling device according to any one of claims 10-28, wherein said laminate includes three or more plate members, including the third, fourth and fifth plate members, that are disposed between said first and second plate members, and
said first plate member and at least one set of plate members disposed closer to said first plate member than to a center of the laminate have substantially the same flow passage structure, or said second plate member and at least one set of plate members disposed closer to said second plate member than to the center of the laminate have substantially the same flow passage structure.

30. A cooling device according to any one of claims 10-29, wherein said laminate includes three or more plate members, including the third, fourth and fifth plate members and a further plate member, that are disposed between said first and second plate members, and
at least one of said third or fourth and further plate members disposed closer to said first plate member than to a center of said laminate is provided with a coolant buffer at a location closer to a center of these plate members than to said through holes provided close to the first side of the plate members, the coolant buffer being a through area extending over an entire width of said coolant supply passage.

31. A cooling device according to any one of claims 21-30, wherein at least either ones of said grooves divided by said first, second, or third ridges and shallower than the thickness of the plate members, the opening separated by said first or second partitions, the through portion separated by said third partitions and forming the flow passage, said through holes provided close to the first side of the plate members, the opening having said first projections, and the through portion having said second projections and forming the flow passage are formed by means of chemical etching.

32. A cooling device according to any one of claims 10-31, wherein said three or more plate members are joined and stacked together by means of diffusion welding.

33. A cooling device according to any one of claims 10-31, wherein a solder layer is formed on at least a joining face of at least one of every pair of plate members joined and stacked together and belonging to said three or more plate members.

34. A cooling device according to any one of claims 23-31 and 33, wherein said laminate includes three or more plate members,
at least part of said first through third ridges or said first through fourth partitions or said first or second projections in one of the plate members is so formed as to nearly correspond in position to at least part of said first through third ridges or said first through fourth partitions or said first or second projections in the adjacent plate member, these parts being joined to each other,
at least one set of said first through third ridges or said first through fourth partitions or said first or second projections, which are joined to one another, have different widths measured at their corresponding positions or are deviated in position from one another in a widthwise direction in a range smaller than their widths measured at their corresponding positions, and
solder filets are formed at their joined portions.

35. A cooling device according to any one of claims 1-34, wherein at least one of said first plate member, said second plate member, and said third or fourth and further plate members is made of cupper or a cupper alloy.

36. A cooling device according to any one of claims 1-9 and 33-35, wherein solder of the solder layer used to join the plate members adjacent to each other is a material selected from a group consisting of Sn, a eutectic binary or more complex Sn-based alloy, In, a binary or more complex In-based alloy, Ni, and a binary or more complex Ni-based alloy.

37. A cooling device according to claim 36, wherein said solder layer is formed by means of vapor deposition or plating.

38. A cooling device according to claim 36 or 37, wherein a film of Ni, Ti, Pt, Cr, or the like is formed to provide a primary coating for said solder layer.

39. A cooling device according to any one of claims 1-22, wherein said inlet opening, said outlet opening, said coolant flow passage, said through portion used to position the cooling device, said vacant space, which are to be formed in the plate members, and the outer shapes of said plate members are
all formed only by means of chemical etching technique including half etching technique.

40. A cooling device according to claim 39, wherein said inlet opening, said outlet opening, said coolant flow passage, said through portion used to position the cooling device, said vacant space, which are to be formed in the plate members, and the outer shapes of said plate members are all formed only by means of half etching deeper than half the thickness of the plate member from one face of each plate member and half etching deeper than half the thickness of the plate member from another opposite face of each plate member.

41. A cooling device according to any one of claims 23-40, wherein the following are all formed only by means of chemical etching technique including half etching technique: said inlet and outlet openings formed in the plate member; said groove provided in said second plate member at a position corresponding to the opening and separated by said first ridges; said opening provided in said first plate member and separated by said first partitions; said opening formed in said third or fourth and further plate members and having said first projections or separated by said second partitions; said groove provided in the opening of said third or fourth and further plate members and separated by said third ridges; said through portion having said groove that is provided at area other than an area corresponding to the opening, used as a coolant flow passage, and separated by said second ridges, or having the second projections, or separated by the third partitions; said through hole array provided close to the first side of the plate members and separated by the fourth partitions; said through portion used to position the cooling device; said vacant space; and the outer shapes of the plate members.

42. A cooling device according to claim 41, wherein the following are all formed only by means of half etching deeper than half the thickness of the plate member from one face of each plate member and half etching deeper than half the thickness of the plate member from another opposite plate member: said inlet and outlet openings formed in the plate members; said groove provided in said second plate member at a position corresponding to the opening and separated by said first ridges; said opening provided in said first plate member and separated by said first partitions; said opening formed in said third or fourth and further plate members and having said first projections or separated by said second partitions; said groove provided in the opening of said third or fourth and further plate members and separated by said third ridges; said groove separated by said second ridges that is provided at area other than an area corresponding to the opening, used as a coolant flow passage, and separated by said second ridges, or having the second projections, or separated by the third partitions; said through hole array provided close to the first side of the plate members and separated by the fourth partitions; said through portion used to position the cooling device; said vacant space; and the outer shapes of the plate members.

43. A cooling device according to any one of claims 1-38, wherein a semiconductor laser as the semiconductor component is mounted.

44. A cooling device according to claim 43, wherein said semiconductor laser is an edge-emitting semiconductor laser.

45. A cooling device according to claim 44, wherein said surface-emitting semiconductor laser is a monolithic linear array provided with a plurality of laser emitters, and
the linear array has a width which is substantially equal to a width of the through holes or an entire width of the through hole array including the fourth partitions, the through holes or the through hole array being provided close to the first side of the plate members.

46. A cooling device according to any one of claims 43-45, wherein said semiconductor laser is mounted to said cooling device through a substrate for semiconductor laser mounting, and
a solder layer is formed at least a semiconductor laser mounting face and a joining face of said substrate, the substrate being joined at the joining face to said cooling device.

47. A cooling device according to claim 46, wherein at least one recess or groove is formed in at least either one of that joining face of said substrate for semiconductor laser mounting at which the substrate is joined to said cooling device and that mounting face of said cooling device on which said substrate for semiconductor laser mounting is mounted, and
a solder filet is formed between said joining face of said substrate for semiconductor laser mounting and said mounting face of said cooling device.

48. A cooling device according to any one of claims 43-47, wherein, using an insulating film whose opposite faces have an ability of adhesion, a thin metal sheet having a thickness about 50 µm or equal to or less than 100 µm is bonded to an outface of said cooling device to which said semiconductor laser is mounted, and
said thin metal sheet is soldered to an electrode of said semiconductor laser having another electrode thereof provided in that face of said semiconductor laser which is used to mount the semiconductor laser to said cooling device or to said substrate for semiconductor laser mounting, whereby wiring used for electric current supply to said semiconductor laser is performed.

49. A cooling device according to claim 48, wherein said insulating film is a double-sided adhesive thermosetting insulating film which is softened and exhibits adhesiveness when heated, which is hardened when returned to room temperature, and through which physical objects individually disposed on both sides of said film are bonded together.

50. A cooling device according to claim 49, wherein said double-sided adhesive thermosetting insulating film has thermosetting adhesive layers formed in opposite faces thereof and an insulating layer disposed in a center thereof and comprised of a resin layer or the like hardly softened when heated.

51. A cooling device according to any one of claims 48-50, wherein a resin layer of polyimide or the like is formed in at least part of said thin metal sheet.

52. A cooling device according to any one of claims 48-51, wherein at least one slit is formed in or near at least those portions of said thin metal sheet which are soldered to the electrode of said semiconductor laser.

53. A cooling device according to any one of claims 48-52, wherein at least either one of said insulating film and said thin metal sheet is formed with a notch used to position the insulating film or the thin metal sheet when the thin metal sheet is bonded to said cooling device through the insulating film.
